(19) Europäisches Patentamt / European Patent Office / Office européen des brevets

(11) **EP 4 749 920 A1**

(12) **EUROPEAN PATENT APPLICATION**
published in accordance with Art. 153(4) EPC

(43) Date of publication:
27.05.2026 Bulletin 2026/22

(21) Application number: 24895837.3

(22) Date of filing: 30.08.2024

(51) International Patent Classification (IPC):
*H03H 9/17* (2006.01)

(52) Cooperative Patent Classification (CPC):
H03H 3/02; H03H 9/02; H03H 9/13; H03H 9/17;
H03H 9/56; H03H 9/70

(86) International application number:
PCT/CN2024/115982

(87) International publication number:
WO 2025/112736 (05.06.2025 Gazette 2025/23)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 30.11.2023 CN 202311635958

(71) Applicant: Huawei Technologies Co., Ltd.
Shenzhen, Guangdong 518129 (CN)

(72) Inventors:
• ZHANG, Naiqing
  Shenzhen, Guangdong 518129 (CN)
• PLESSKI, Viktor
  Shenzhen, Guangdong 518129 (CN)

(74) Representative: Grünecker Patent- und
Rechtsanwälte
PartG mbB
Leopoldstraße 4
80802 München (DE)

(54) **RESONATOR, FILTER AND ELECTRONIC DEVICE**

(57)    This application provides a resonator, a filter, and an electronic device, and relates to the field of resonator technologies. The resonator can increase an electromechanical coupling factor. The resonator may include a substrate, a first electrode, a multi-layer piezoelectric layer, and a plurality of second electrodes. The first electrode, the multi-layer piezoelectric layer, and the plurality of second electrodes are disposed on the substrate. The multi-layer piezoelectric layer has a first side and a second side. The plurality of second electrodes are located on the first side and are arranged side by side in a first direction. The first electrode is located on the second side, the first side faces away from the substrate, and the second side faces toward the substrate. The multi-layer piezoelectric layer includes a first piezoelectric layer and a second piezoelectric layer that are stacked. A piezoelectric material of the first piezoelectric layer has a first piezoelectric tensor component $e_{34}$, a piezoelectric material of the second piezoelectric layer has a second piezoelectric tensor component $e_{34}$, and the first piezoelectric tensor component $e_{34}$ is opposite to the second piezoelectric tensor component $e_{34}$. The piezoelectric layers with piezoelectric tensor components $e_{34}$ that are opposite to each other are used, so that the resonator can have a large vibration, thereby increasing the electromechanical coupling factor.

FIG. 5

EP 4 749 920 A1

**Description**

This application claims priority to Chinese Patent Application No. 202311635958.3, filed with the China National Intellectual Property Administration on November 30, 2023 and entitled "RESONATOR, FILTER, AND ELECTRONIC DEVICE", which is incorporated herein by reference in its entirety.

**TECHNICAL FIELD**

This application relates to the field of resonator technologies, and relates to a resonator, a filter, an electronic device including the filter or the resonator, and a preparation method for the resonator or the filter.

**BACKGROUND**

With development of communication technologies, a quantity of resonators needed for an electronic device significantly increases. For example, bulk acoustic resonators such as a horizontally-excited bulk acoustic resonator (Horizontally-excited Bulk Acoustic Resonator, XBAR), a vertically-excited bulk acoustic resonator (Vertically-excited Bulk Acoustic Resonator, YBAR), and a film bulk acoustic resonator (Film Bulk Acoustic Resonator, FBAR) have attracted wide attention.

The YBAR has larger coupling and a more efficient resonance mode, and may be used at higher passband bandwidth.

However, in the YBAR device, because a piezoelectric layer is attached to a substrate, an acoustic resonance vibration of a part that is of the piezoelectric layer and that is close to the substrate is limited. As a result, increase of an electromechanical coupling factor of the resonator is suppressed.

**SUMMARY**

This application provides a resonator, a filter having the resonator, an electronic device including the filter or the resonator, and a preparation method for the resonator. Therefore, the resonator that can increase an electromechanical coupling factor is provided.

To achieve the foregoing objective, the following technical solutions are used in embodiments of this application.

According to an aspect, this application provides a resonator. In an embodiment, the resonator may be an acoustic resonator, for example, a YBAR.

The resonator includes a substrate, a first electrode, a multi-layer piezoelectric layer, and a plurality of second electrodes. The first electrode, the multi-layer piezoelectric layer, and the plurality of second electrodes are disposed on the substrate. The multi-layer piezoelectric layer has a first side and a second side. The plurality of second electrodes are located on the first side and are arranged side by side in a first direction. The first electrode is located on the second side, the first side faces away from the substrate, and the second side faces toward the substrate. The multi-layer piezoelectric layer includes a first piezoelectric layer and a second piezoelectric layer that are stacked. A piezoelectric material of the first piezoelectric layer has a first piezoelectric tensor component $e_{34}$, a piezoelectric material of the second piezoelectric layer has a second piezoelectric tensor component $e_{34}$, and the first piezoelectric tensor component $e_{34}$ is opposite to the second piezoelectric tensor component $e_{34}$. In other words, the first piezoelectric tensor component $e_{34}$ and the second piezoelectric tensor component $e_{34}$ are opposite numbers of each other.

In the resonator provided in this application, the piezoelectric layer includes a plurality of layers, for example, includes the first piezoelectric layer and the second piezoelectric layer that are stacked. The first piezoelectric tensor component $e_{34}$ of the first piezoelectric layer is opposite to the second piezoelectric tensor component $e_{34}$ of the second piezoelectric layer. In this case, under action of an electric field, a deformation direction of the first piezoelectric layer is opposite to a deformation direction of the second piezoelectric layer. For example, when a vibration direction of a part that is of the first piezoelectric layer and that is attached to the second piezoelectric layer extends toward a direction away from the piezoelectric layer in an extension direction of the second electrode, a vibration direction of a part that is of the second piezoelectric layer and that is attached to the first piezoelectric layer also vibrates toward the direction away from the piezoelectric layer in the extension direction of the second electrode. The two vibrations are coupled and resonated at a position at which the first piezoelectric layer is attached to the second piezoelectric layer, so that a mechanical vibration is also generated inside the entire piezoelectric layer, thereby increasing an electromechanical coupling factor of the entire resonator.

In an implementation, the first electrode has a first surface and a second surface that are opposite to each other, the first surface is closer to the piezoelectric layer than the second surface, and the second surface of the first electrode is completely disposed on the substrate.

The resonator provided in this example may be referred to as a solid-state substrate resonator. The resonator with this structure can improve a heat dissipation capability and firmness of the device.

In an implementation, there is a spacing between two adjacent second electrodes. A groove is disposed at a position that is of the multi-layer piezoelectric layer and that is opposite to the spacing, and the groove penetrates the spacing.

Because the groove is formed in the piezoelectric layer, the groove helps further increase the electromechanical coupling factor of the resonator, and can further suppress or frequency-shift a parasitic spurious mode.

In an implementation, a thickness dimension of the multi-layer piezoelectric layer is H, a depth dimension of the groove is h, and 30% H≤h≤H.

When the depth dimension of the groove is small, a vibration of a part that is of the piezoelectric layer and that is located between the first electrode and the second electrode is constrained.

In an implementation, the first piezoelectric layer is disposed closer to the substrate than the second piezoelectric layer. The second piezoelectric layer has a top surface facing away from the first piezoelectric layer, the first piezoelectric layer has a bottom surface facing away from the second piezoelectric layer, and the groove penetrates the top surface and the bottom surface.

Because the groove penetrates from the top surface of the piezoelectric layer to the bottom surface, the electromechanical coupling factor can be further increased.

In an implementation, a radial dimension of the groove is gradually increased from the top surface to the bottom surface.

For example, a tilt angle α of a side surface of the groove satisfies: 45°<α<90°, or 60°<α<90°.

In an implementation, a thickness dimension of the second electrode is S1, the thickness dimension of the multi-layer piezoelectric layer is H, and $S1/H \leq 0.35$.

In an implementation, a thickness dimension of the first electrode is S2, the thickness dimension of the multi-layer piezoelectric layer is H, and $S2/H \leq 0.35$.

In some examples, to reduce an acoustic loss at the electrode, the thickness dimension of the first electrode or the second electrode may be reduced. However, when the thickness dimension of the electrode is reduced, a power tolerance capability of the electrode is weakened. In this example of this application, a ratio of the thickness of the electrode to the thickness of the piezoelectric layer may be reduced by increasing the thickness dimension of the piezoelectric layer. In this way, no challenge is posed to an etching process, and the power tolerance capability of the electrode is not weakened.

In an implementation, the resonator further includes a first busbar and a second busbar. In every two adjacent second electrodes in the plurality of second electrodes, one second electrode is a first interdigital electrode, and the other second electrode is a second interdigital electrode. The first interdigital electrode and the second interdigital electrode are spaced from each other in the first direction. A plurality of first interdigital electrodes in the plurality of second electrodes are connected to each other through the first busbar, and a plurality of second interdigital electrodes in the plurality of second electrodes are connected to each other through the second busbar. A pitch P and the thickness dimension H of the multi-layer piezoelectric layer satisfy: P/H≥1. A width dimension of each first interdigital electrode is t1, a spacing between each first interdigital electrode and each second interdigital electrode that are adjacent to each other is t2, the pitch P is equal to t1+t2, and the width dimension is a dimension that is parallel to a surface of the substrate and that is perpendicular to an extension direction of the first interdigital electrode.

To increase a resonance frequency of the resonator, the pitch P may be reduced. However, a small pitch P not only poses a challenge to the etching process, but also causes a parasitic spurious mode. In this embodiment of this application, because a plurality of stacked piezoelectric layers are used, a ratio of the pitch to the thickness of the piezoelectric layer is limited. This does not pose the challenge to the etching process, but also can suppress the parasitic spurious mode.

In a possible implementation, a thickness dimension of the first piezoelectric layer is S1, a thickness dimension of the second piezoelectric layer is S2, and S1 is equal to or approximately equal to S2.

In an implementation, based on a voltage being applied to the plurality of second electrodes, the resonator is configured to excite the multi-layer piezoelectric layer to generate a first resonance mode, where a vibration direction of the first resonance mode is parallel to an extension direction of the second electrode.

In an implementation, an electromechanical coupling factor $Kt^2$ of the resonator is greater than or equal to 24%.

In an implementation, the piezoelectric materials of the first piezoelectric layer and the second piezoelectric layer include at least one of a combination of niobium and lithium and a combination of tantalum and lithium.

In a feasible implementation, a dielectric layer is stacked between the substrate and the first electrode, and a thickness g of the dielectric layer satisfies: g=λ/4, where λ is a wavelength of an acoustic wave of the resonator at the resonance frequency in a material of the dielectric layer.

The dielectric layer is disposed between the substrate and the first electrode to prevent coupling between the piezoelectric layer and the substrate, so that the electromechanical coupling factor of the device can be increased. In addition, when the thickness g of the dielectric layer satisfies: $g=\lambda/4$, the electromechanical coupling factor can be further increased.

In an implementation, the first piezoelectric layer and the second piezoelectric layer are adjacent layers.

In an implementation, polarities of the first piezoelectric layer and the second piezoelectric layer are opposite.

In this way, a larger mechanical vibration can be more easily generated inside the piezoelectric layer, thereby increasing the electromechanical coupling factor.

In an implementation, piezoelectric tensor components $e_{31}$, $e_{32}$, $e_{33}$, $e_{14}$, $e_{24}$, $e_{15}$, $e_{25}$, and $e_{36}$ of the piezoelectric material of the first piezoelectric layer are the same as corresponding piezoelectric tensor components $e_{31}$, $e_{32}$, $e_{33}$, $e_{14}$, $e_{24}$, $e_{15}$, $e_{25}$, and $e_{36}$ of the piezoelectric material of the second piezoelectric layer; and piezoelectric tensor components $e_{11}$, $e_{12}$, $e_{13}$, $e_{16}$, $e_{21}$, $e_{22}$, $e_{23}$, $e_{26}$, and $e_{35}$ of the piezoelectric material of the first piezoelectric layer are opposite to corresponding piezoelectric tensor components $e_{11}$, $e_{12}$, $e_{13}$, $e_{16}$, $e_{21}$, $e_{22}$, $e_{23}$, $e_{26}$, and $e_{35}$ of the piezoelectric material of the second piezoelectric layer.

When the first piezoelectric layer rotates 180° around an axis perpendicular to a plane of the first piezoelectric layer, and the two piezoelectric layers meet requirements of the piezoelectric tensor components, the polarities of the two piezoelectric layers may be opposite.

In an implementation, piezoelectric tensor components $e_{11}$, $e_{12}$, $e_{13}$, $e_{14}$, $e_{25}$, $e_{35}$, $e_{26}$, and $e_{36}$ of the piezoelectric material of the first piezoelectric layer are the same as corresponding piezoelectric tensor components $e_{11}$, $e_{12}$, $e_{13}$, $e_{14}$, $e_{25}$, $e_{35}$, $e_{26}$, and $e_{36}$ of the piezoelectric material of the second piezoelectric layer; and piezoelectric tensor components $e_{15}$, $e_{16}$, $e_{21}$, $e_{22}$, $e_{23}$, $e_{24}$, $e_{31}$, $e_{32}$, and $e_{33}$ of the piezoelectric material of the first piezoelectric layer are opposite to corresponding piezoelectric tensor components $e_{15}$, $e_{16}$, $e_{21}$, $e_{22}$, $e_{23}$, $e_{24}$, $e_{31}$, $e_{32}$, and $e_{33}$ of the piezoelectric material of the second piezoelectric layer.

When the first piezoelectric layer rotates 180° around an axis that is parallel to a plane of the first piezoelectric layer and that is perpendicular to the extension direction of the second electrode, and the two piezoelectric layers meet requirements of the piezoelectric tensor components, the polarities of the two piezoelectric layers may be opposite.

In an implementation, Euler angles of a crystal of the piezoelectric material of the first piezoelectric layer are (0°, 90°, 0°), and Euler angles of a crystal of the piezoelectric material of the second piezoelectric layer are (0°, 90°, 180°);

Euler angles of a crystal of the piezoelectric material of the first piezoelectric layer are (0°, 270°, 0°), and Euler angles of a crystal of the piezoelectric material of the second piezoelectric layer are (0°, 270°, 180°); or

Euler angles of a crystal of the piezoelectric material of the first piezoelectric layer are (90°, 90°, 210°), and Euler angles of a crystal of the piezoelectric material of the second piezoelectric layer are (90°, 90°, 30°).

According to another aspect, this application further provides a filter. The filter may include a plurality of electrically connected resonators. At least one of the plurality of resonators may be the resonator described above.

The filter provided in this application includes the resonator in the foregoing implementation structure, and the resonator includes at least two piezoelectric layers with opposite polarization directions, so that the resonator has a large electromechanical coupling factor. Using the resonator in the filter can improve out-of-band rejection performance of the filter.

According to still another aspect, this application further provides a duplexer. The duplexer includes a transmit channel filter and a receive channel filter. At least one of the transmit channel filter and the receive channel filter may be the foregoing filter for filtering.

According to yet another aspect, this application further provides a multiplexer. The multiplexer includes a plurality of transmit channel filters and a plurality of receive channel filters. At least one of the plurality of transmit channel filters or at least one of the plurality of receive channel filters may be the filter in embodiments of this application.

According to still yet another aspect, this application further provides an electronic device. The electronic device includes an amplifier, and the filter, the duplexer, or the multiplexer in the foregoing feasible implementations. The filter, the duplexer, or the multiplexer may be electrically connected to the amplifier.

The electronic device provided in embodiments of this application includes the foregoing filter, duplexer, or multiplexer. Therefore, the electronic device provided in embodiments of this application and the filter, the duplexer, or the multiplexer in the foregoing technical solutions can resolve a same technical problem, with same expected effect achieved.

According to a further aspect, this application further provides a preparation method for a resonator. The preparation method includes:

preparing a first electrode on a substrate; and
preparing a first piezoelectric layer and a second piezoelectric layer that are stacked on the first electrode, and preparing a plurality of second electrodes on the second piezoelectric layer, where the plurality of second electrodes are arranged side by side in a first direction.

A piezoelectric material of the first piezoelectric layer has a first piezoelectric tensor component $e_{34}$, a piezoelectric material of the second piezoelectric layer has a second piezoelectric tensor component $e_{34}$, and the first piezoelectric tensor component $e_{34}$ is opposite to the second piezoelectric tensor component $e_{34}$.

In the resonator prepared by using the preparation method in this application, because the first piezoelectric tensor component $e_{34}$ of the piezoelectric material of the first piezoelectric layer is opposite to the second piezoelectric tensor component $e_{34}$ of the piezoelectric material of the second piezoelectric layer, coupling resonance is generated at a position at which the first piezoelectric layer is attached to the second piezoelectric layer, so that a mechanical vibration is also generated inside the entire piezoelectric layer, thereby increasing an electromechanical coupling factor of the entire resonator.

In a possible implementation, preparing the first electrode on the substrate, preparing the first piezoelectric layer and the second piezoelectric layer that are stacked on the first electrode, and preparing the plurality of second electrodes on the second piezoelectric layer include:

preparing the first electrode on a side of a first piezoelectric wafer, bonding the substrate to the first piezoelectric wafer, and thinning the first piezoelectric wafer, to prepare the first piezoelectric layer, where the first electrode is located between the first piezoelectric layer and the substrate;

bonding a second piezoelectric wafer to the first piezoelectric wafer, and thinning the second piezoelectric wafer, to prepare the stacked first piezoelectric layer and second piezoelectric layer; and

preparing the plurality of second electrodes on the second piezoelectric layer.

In this example, a resonator having a multi-layer piezoelectric layer may be prepared in a piezoelectric wafer bonding manner.

In a possible implementation, the preparation method further includes: disposing a groove at a position that is on the first piezoelectric layer and the second piezoelectric layer and that is opposite to a spacing between two adjacent second electrodes, for the groove to penetrate the spacing.

The groove may be used to further increase the electromechanical coupling factor, or may be used to suppress a parasitic spurious mode.

According to a still further aspect, this application further provides a preparation method for a filter. The preparation method may include the foregoing preparation method for the resonator.

In the filter prepared by using this method, because a first piezoelectric tensor component $e_{34}$ of a piezoelectric material of a first piezoelectric layer is opposite to a second piezoelectric tensor component $e_{34}$ of a piezoelectric material of a second piezoelectric layer, coupling resonance is generated at a position at which the first piezoelectric layer is attached to the second piezoelectric layer, so that a mechanical vibration is also generated inside the entire piezoelectric layer, thereby increasing an electromechanical coupling factor of the entire resonator, and optimizing performance of the filter.

## BRIEF DESCRIPTION OF DRAWINGS

FIG. 1 is a diagram of a partial structure of an electronic device;

FIG. 2 is a diagram of a partial structure of an electronic device;

FIG. 3 is a diagram of a partial structure of a filter in an electronic device;

FIG. 4 is a diagram of a partial structure of a resonator;

FIG. 5 is a diagram of a partial structure of a resonator according to an embodiment of this application;

FIG. 6 is a diagram of a structure for indicating a vibration of a resonator according to an embodiment of this application;

FIG. 7 is a diagram of a structure for indicating a vibration of a resonator according to a related technology;

FIG. 8 is a diagram of a structure for indicating a vibration of a resonator according to a related technology;

FIG. 9 is a diagram of a partial structure of a resonator according to an embodiment of this application;

FIG. 10 is a diagram of a partial structure of a resonator according to an embodiment of this application;

FIG. 11 is a diagram of a structure for indicating a vibration of a resonator according to a related technology;

FIG. 12 is a diagram of a structure for indicating a vibration of a resonator according to an embodiment of this application;

FIG. 13 is a diagram of a partial structure of a resonator according to an embodiment of this application;

FIG. 14 is a diagram of a partial structure of a resonator according to an embodiment of this application;

FIG. 15A is a diagram of a structure for indicating a vibration of a resonator according to a related technology;

FIG. 15B is a diagram of a structure for indicating a vibration of a resonator according to an embodiment of this application;

FIG. 16A is a diagram of a structure for indicating a vibration of a resonator according to a related technology;

FIG. 16B is a diagram of a structure for indicating a vibration of a resonator according to an embodiment of this application;

FIG. 17A is a diagram of an admittance curve of the structure shown in FIG. 15A;

FIG. 17B is a diagram of an admittance curve of the structure shown in FIG. 15B;

FIG. 18 is a diagram of a partial structure of a resonator according to an embodiment of this application;

FIG. 19 is a diagram of a partial structure of a resonator according to an embodiment of this application;

FIG. 20 is a diagram of a partial structure of a resonator according to an embodiment of this application;

FIG. 21 is a diagram of a structure for indicating a vibration of a resonator according to a related technology;

FIG. 22 is a diagram of an admittance curve of the structure shown in FIG. 20;

FIG. 23 is a diagram of an admittance curve of the structure shown in FIG. 21;

FIG. 24 is a diagram of an admittance curve of the structure shown in FIG. 20;

FIG. 25 is a diagram of an admittance curve of the structure shown in FIG. 21;

FIG. 26 is a process flowchart of a preparation method for a resonator according to an embodiment of this application;

FIG. 27A to FIG. 27F are diagrams of process structures after steps in a preparation method for a resonator are completed according to an embodiment of this application;

FIG. 28 is a diagram of a structure of a filter according to an embodiment of this application; and

FIG. 29 is a diagram of admittance curves of resonators in FIG. 28 and a passband of a filter.

Reference numerals:

100: electronic device;
200: filter;
300: resonator;
400, 410, 420, 430, and 440: resonator;
500: antenna;
600: receiver;
700: transmitter;
800: baseband chip;
900: switch;
60a, 60c, and 70a: filter; 60b: low-noise amplifier; 60d: frequency mixer; 60e: buffer; 60f and 70d: voltage-controlled oscillator; 70b: amplifier; 70c: driver;
10: substrate; 101: cavity;
20: first electrode;
30: piezoelectric layer; 301: first piezoelectric layer; 302: second piezoelectric layer;
40: second electrode; 401: first interdigital electrode; 402: second interdigital electrode;
50: dielectric layer;
601: first busbar; 602: second busbar; and
70: groove.

## DESCRIPTION OF EMBODIMENTS

Before a structure that can be implemented in embodiments of this application is described, technical terms in embodiments of this application are first described.

Piezoelectric effect: includes positive piezoelectric effect and inverse piezoelectric effect. The positive piezoelectric effect means that electric polarization of a piezoelectric material changes when the piezoelectric material is subject to a mechanical force. The inverse piezoelectric effect means that a piezoelectric material is deformed after an external electric field is applied to the material. The piezoelectric effect is mainly caused by anisotropy and polarization of a crystal structure of the piezoelectric material.

Primary resonance mode and parasitic spurious mode: A position of a parasitic resonance frequency generated by a resonator may be close to a position of a primary resonance frequency, and parasitic resonance may affect the primary resonance mode, and further affect in-band insertion loss performance and out-of-band rejection performance of a filter. The parasitic resonance of the resonator is usually referred to as a spurious mode or the parasitic spurious mode. When the spurious mode falls near the primary resonance mode, for example, falls near a resonance point and an anti-resonance point of the primary resonance mode, the in-band insertion loss performance and the out-of-band rejection performance of the filter are affected.

Electromechanical coupling factor (Piezoelectric coupling factor) $Kt^2$: is a key parameter of a resonator. The

electromechanical coupling factor $Kt^2$ may indicate efficiency of conversion between mechanical energy and electric energy. The electromechanical coupling factor $Kt^2$ of the resonator determines relative frequency width of an anti-resonance frequency and a resonance frequency of the resonator. For example, when the resonator is used in a filter design, the relative frequency width directly determines bandwidth of the filter. It can be considered that a larger electromechanical coupling factor $Kt^2$ indicates higher bandwidth and better performance of a filter constructed in a trapezoidal structure.

A single-crystal piezoelectric material has a fourth-order elastic tensor c, a third-order piezoelectric tensor e, and a second-order dielectric tensor $\varepsilon$. Based on a right-handed rectangular coordinate system, the single-crystal piezoelectric material has an elastic tensor component $c_{ijkl}$, a piezoelectric tensor component $e_{ijk}$, and a dielectric tensor component $\varepsilon_{ij}$, where i, j, k, l={1, 2, 3}. Due to symmetry of a single-crystal structure, for example, $c_{1323}=c_{3132}$, an order of a component can be simplified, and the following definitions may be made: {23, 32}→4, {13, 31}→5, and {12, 21}→6. For example, $c_{1323}=c_{3132}\to c_{54}$. In this case, an elastic tensor component $c_{xy}$ (6*6), a piezoelectric tensor component $e_{ix}$ (3*6), and a dielectric tensor component $\varepsilon_{ij}$ (3*3) are obtained, where i, j = {1, 2, 3}, and x, y={1, 2, 3, 4, 5, 6}. An electromechanical coupling factor component $k_{xy}^2$ is obtained by calculating the elastic tensor component, the piezoelectric tensor component, and the dielectric tensor component of the material. A formula is as follows:

$$k_{xy}{}^2 = \frac{e_{xy}{}^2}{\varepsilon_{xx}{}^S c_{yy}{}^E}$$

Herein, x={1, 2, 3}, y={1, 2, 3, 4, 5, 6}, $\varepsilon_{xx}{}^S$ is a dielectric tensor component under fixed strain, and $c_{yy}{}^E$ is an elastic tensor component under fixed electric field strength.

The following describes methods and formulas for calculating elastic tensor components, piezoelectric tensor components, and dielectric tensor components at different Euler angles of crystals.

For a crystal orientation of a piezoelectric material with Euler angles of (0, 0, 0), for example, LN,

$c^E_{11}=2.03$, $c^E_{12}=0.53$, $c^E_{13}=0.75$, $c^E_{14}=0.09$, $c^E_{44}=0.60$, $c^E_{33}=2.43$, $c^E_{22}=c^E_{11}$, $c^E_{23}=c^E_{13}$, $c^E_{24}=-c^E_{14}$, $c^E_{55}=c^E_{44}$, $C^E_{56}=c^E_{14}$, and $c^E_{66}=(c^E_{11}-c^E_{12})/2$, in $*10^{11}$ N/m²; and

$e_{15}=3.70$, $e_{16}=-2.53$, $e_{31}=0.19$, $e_{33}=1.31$, $e_{21}=e_{16}$, $e_{22}=-e_{16}$, $e_{24}=e_{15}$, and $e_{32}=e_{31}$, in C/m²; and $\varepsilon^S_{11}=43.6*\varepsilon_0$, $\varepsilon^S_{33}=29.2*\varepsilon_0$, and $\varepsilon^S_{22}=\varepsilon^S_{11}$, where $\varepsilon_0$ is a vacuum dielectric constant: $8.85*10^{-12}$ F/m. Other components may be obtained based on tensor symmetry, and a component without a value is zero. The components are expressed in simplified forms. A fourth-order elastic tensor component $c^E_{ijkl}$ and a third-order piezoelectric tensor component $e_{ijk}$ may be correspondingly obtained through expansion.

In this case, for a crystal orientation of a piezoelectric material with Euler angles of ($\alpha$, $\beta$, $\gamma$), an elastic tensor component $c^E_{pqrs}'$, a piezoelectric tensor component $e_{pqr}'$, and a dielectric tensor component $\varepsilon^S_{pq}'$ that correspond to the crystal orientation may be calculated according to the following formulas:

$$c^E_{pqrs}'=c^E_{ijkl}\,A_{ip}\,A_{jq}\,A_{kr}\,A_{ls};$$

$$e_{pqr}'=e_{ijk}\,A_{ip}\,A_{jq}\,A_{kr};$$

and

$$\varepsilon^S_{pq}'=\varepsilon^S_{ij}\,A_{ip}\,A_{jq}.$$

Einstein summation convention is used in the formula, where a 3*3 matrix A=($\cos\alpha\cos\gamma-\sin\alpha\cos\beta\sin\gamma$, $-\cos\alpha\sin\gamma-\sin\alpha\cos\beta\cos\gamma$, $\sin\alpha\sin\beta$; $\sin\alpha\cos\gamma+\cos\alpha\cos\beta\sin\gamma$, $-\sin\alpha\sin\gamma+\cos\alpha\cos\beta\cos\gamma$, $-\cos\alpha\sin\beta$; $\sin\beta\sin\gamma$, $\sin\beta\cos\gamma$, $\cos\beta$).

Euler angles (Euler angles) of a piezoelectric material: The Euler angles (Euler angles) represent a relative rotation angle relationship between an X direction or a Y direction of an original piezoelectric crystal structure and a direction, on a wafer plane, that is perpendicular or parallel to an electrode extension direction of a resonator.

Admittance (admittance): In power electronics, the admittance is defined as a reciprocal of impedance (impedance), is represented by a symbol Y, is measured in Siemens, and is briefly referred to as S (S). Like the impedance, the admittance is also a complex number, including a real number part (conductance G) and an imaginary number part (susceptance B): Y=G+jB.

Admittance curve abs and admittance curve Re: Admittance curve abs (Y)=|Y|, which is a modulus (also referred to as an amplitude) of Y and represents an overall response of a resonator. Re (Y) is a real part of Y, that is, conductance G, and represents a loss of the resonator.

Embodiments of this application provide an electronic device. The electronic device includes but is not limited to a radio frequency front-end, a filter and amplification module, and other products, and may further include a mobile phone (mobile phone), a tablet computer (pad), an intelligent wearable product (for example, a smartwatch or a smart band), a virtual reality (virtual reality, VR) device, an augmented reality (augmented reality, AR) device, an uncrewed aerial vehicle, or other terminal devices, or may be a base station, a television, a router, a vehicle, or another device. A specific form of the electronic device is not particularly limited in embodiments of this application.

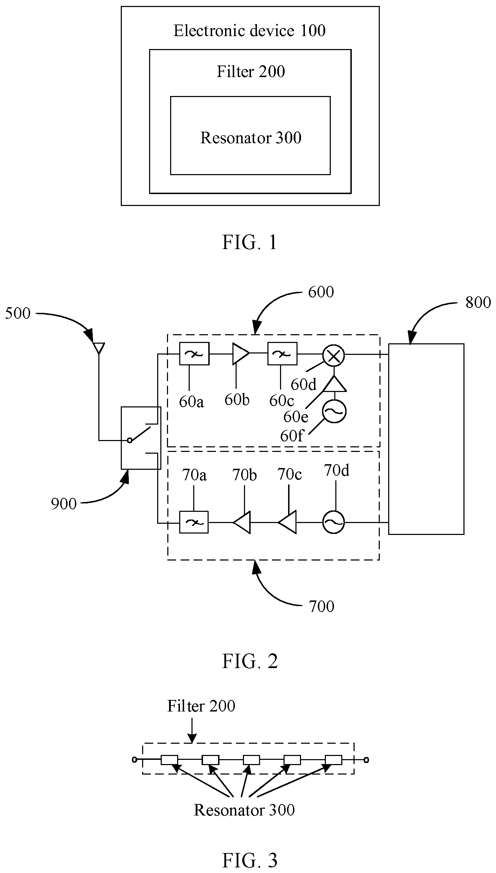

In the foregoing electronic device, as shown in FIG. 1, the electronic device 100 may include a filter 200. The filter 200 may effectively filter out a frequency of a specific frequency in a signal or a frequency other than the frequency, to obtain a signal with a specific frequency or a signal from which a specific frequency is eliminated, to improve operating performance of the electronic device 100.

FIG. 2 is a diagram of a partial circuit of some electronic devices 100. As shown in FIG. 2, the electronic device 100 includes a receiver (Receiver) 600, a transmitter (Transmitter) 700, an antenna (Antenna) 500, and a baseband chip 800. The antenna 500 is electrically connected to the receiver 600 and the transmitter 700 through a switch 900, and the receiver 600 and the transmitter 700 are electrically connected to the baseband chip 800.

The receiver (Receiver) 600 shown in FIG. 2 includes a filter (Filter) 60a and a filter (Filter) 60c. A low-noise amplifier 60b is electrically connected between the filter 60a and the filter 60c. The filter 60c is electrically connected to a buffer (Buffer) 60e through a frequency mixer (Mixer) 60d. The buffer 60e is electrically connected to a voltage-controlled oscillator 60f. FIG. 2 shows merely an example receiver, and an electronic component may be added or reduced based on this circuit structure.

The transmitter (Transmitter) 700 shown in FIG. 2 includes a power amplifier (power amplifier, PA) 70b. The power amplifier 70b is electrically connected to a filter 70a and a driver (Driver) 70c. The driver (Driver) 70c is electrically connected to a voltage-controlled oscillator 70d. Similarly, FIG. 2 shows merely an example transmitter, and an electronic component may be added or reduced based on this circuit structure.

For example, in the transmitter 700 shown in FIG. 2, the filter may effectively filter out a frequency of a specific frequency amplified by the power amplifier or a frequency other than the frequency, or the filter may filter out noise of the low-noise amplifier.

Further, as shown in FIG. 3, the filter 200 may include a plurality of resonators 300 that are connected in series, or include a plurality of resonators 300 that are connected in parallel, or include resonators 300 that are connected in series and parallel.

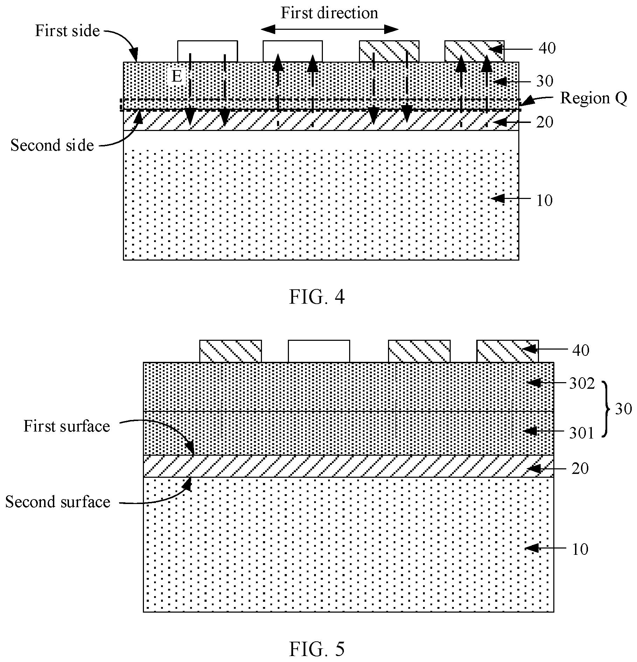

At least one of the plurality of resonators included in the filter 200 may be a resonator shown in FIG. 4.

FIG. 4 shows a part of a diagram of a process structure of a resonator. The resonator includes a substrate 10, a first electrode 20, a piezoelectric layer 30, and a plurality of second electrodes 40. The first electrode 20, the piezoelectric layer 30, and the plurality of second electrodes 40 are disposed on the substrate 10. The plurality of second electrodes 40 are arranged side by side in a first direction. The piezoelectric layer 30 has a first side and a second side. The plurality of second electrodes 40 are located on the first side, the first electrode 20 is located on the second side, the first side faces away from the substrate 10, and the second side faces toward the substrate 10. For example, as shown in FIG. 4, the piezoelectric layer 30 is stacked between the first electrode 20 and the plurality of second electrodes 40.

In the resonator shown in FIG. 4, the plurality of second electrodes 40 are arranged in the first direction, and the first direction may be understood as a direction perpendicular to or approximately perpendicular to an extension direction of the second electrodes 40. In an embodiment, the first direction is perpendicular to a direction in which the piezoelectric layer 30, the first electrode 20, and the second electrode 40 are stacked.

The example structure in FIG. 4 may be used in a bulk acoustic resonator. A main function principle of the bulk acoustic resonator is as follows: An input signal of a radio wave is converted into mechanical energy via input and output transducers (Transducer) based on a piezoelectric effect characteristic of a piezoelectric material. Then, the mechanical energy is converted into an electrical signal through processing, to filter out an unnecessary signal and noise, thereby improving signal reception quality.

During operation of the resonator shown in FIG. 4, the first electrode 20 may have no electrical signal connection, and an alternating voltage at a specific frequency is applied to the second electrodes 40, so that an electric field E is generated between the first electrode 20 and the second electrodes 40 in a thickness direction of the piezoelectric layer 30. The piezoelectric layer 30 produces piezoelectric effect based on the electric field. In the example in FIG. 4, the piezoelectric layer 30 is excited by the vertical electric field E to generate resonance, to cause conversion between electric energy and mechanical energy.

In the resonator shown in FIG. 4, resonance is excited in the thickness direction of the piezoelectric layer 30. In an embodiment, the resonator may be referred to as a vertically-excited bulk acoustic resonator (Vertically-excited Bulk Acoustic Resonator, YBAR). The thickness direction of the piezoelectric layer 30 herein may be understood as a direction, parallel to a direction in which a plurality of film layers (the substrate, the first electrode, and the piezoelectric layer) are stacked, on the piezoelectric layer 30.

As shown in FIG. 4, because a part (a region Q outlined by dashed lines in FIG. 4) that is of the piezoelectric layer 30 and that is close to the first electrode 20 is attached to the first electrode 20, an acoustic resonance vibration of the region (the region Q outlined by the dashed lines in FIG. 4) is limited, and a vibration amount of the piezoelectric layer 30 is limited. As a result, an electromechanical coupling factor $Kt^2$ of the resonator is small, and the resonator cannot be used at higher passband bandwidth, for example, cannot satisfy passband bandwidth of a sub-6 GHz frequency band to a sub-15 GHz frequency band.

To increase the electromechanical coupling factor $Kt^2$ of the resonator, this application provides examples of some new process structures of resonators, which are specifically described below.

FIG. 5 is a diagram of a process structure of a resonator according to an embodiment of this application. Same as that in FIG. 4, the resonator includes the substrate 10, and the first electrode 20, the piezoelectric layer 30, and the plurality of second electrodes 40 that are stacked on the substrate 10. In addition, the resonator is also similar to that in FIG. 4 in that the second electrode 20 has a first surface and a second surface that face away from each other, the first surface is closer to the piezoelectric layer 30 than the second surface, and the second surface of the first electrode 20 is completely disposed on the substrate 10. The resonator may be referred to as a solid-state substrate resonator.

A difference between the examples shown in FIG. 5 and FIG. 4 lies in that in FIG. 5, the piezoelectric layer 30 includes a plurality of layers that are stacked. For example, FIG. 5 shows an example in which a first piezoelectric layer 301 and a second piezoelectric layer 302 that are stacked are included. In some other examples, more piezoelectric layers may be included, for example, three layers, four layers, or more layers.

In the multi-layer piezoelectric layer, some piezoelectric tensor components of piezoelectric materials of two adjacent piezoelectric layers are opposite to each other. For example, as shown in FIG. 5, a piezoelectric material of the first piezoelectric layer 301 has a first piezoelectric tensor component, a piezoelectric material of the second piezoelectric layer 302 has a second piezoelectric tensor component, and the first piezoelectric tensor component is opposite to the second piezoelectric tensor component.

In some examples, the substrate 10 may be a high-acoustic-velocity substrate, for example, may be any one of or any combination of silicon carbide (SiC), diamond (diamond), and boron nitride (BN).

The first electrode 20 may be any possible conductive metal, including but not limited to Al, Cu, W, Mo, Ru, and Pt, or may be a conductive metal with high acoustic impedance, including but not limited to W, Ru, Mo, and Pt. These metals with high acoustic impedance help increase an electromechanical coupling factor and a quality factor Q, and further improve use performance of the resonator.

The second electrode 40 may be any possible conductive metal, including but not limited to Al, Cu, W, Mo, Ru, and Pt.

The first electrode 20 and the second electrode 40 may be a same conductive metal or different conductive metals.

In this example of this application, the piezoelectric material of the first piezoelectric layer 301 has a first piezoelectric tensor component $e_{34}$, the piezoelectric material of the second piezoelectric layer 302 has a second piezoelectric tensor component $e_{34}$, and the first piezoelectric tensor component $e_{34}$ is opposite to the second piezoelectric tensor component $e_{34}$.

In this example of this application, that the first piezoelectric tensor component $e_{34}$ is opposite to the second piezoelectric tensor component $e_{34}$ may be understood as that the first piezoelectric tensor component $e_{34}$ and the second piezoelectric tensor component $e_{34}$ are opposite numbers of each other.

The first piezoelectric tensor component $e_{34}$ and the second piezoelectric tensor component $e_{34}$ are the opposite numbers of each other. In some examples, an absolute value of the first piezoelectric tensor component $e_{34}$ is completely equal to an absolute value of the second piezoelectric tensor component $e_{34}$. Alternatively, it may be assumed that an absolute value of the first piezoelectric tensor component $e_{34}$ may be X1 and an absolute value of the second piezoelectric tensor component $e_{34}$ may be X2. $0 < \frac{X1 - X2}{X1} \le 10\%$.

In a bulk acoustic resonator YBAR provided in this application, a main resonance mode of the bulk acoustic resonator YBAR may be determined based on a piezoelectric tensor component $e_{34}$. An absolute value of the piezoelectric tensor component $e_{34}$ may be a largest value in absolute values of all piezoelectric tensor components, or may be less than a largest value in absolute values of piezoelectric tensor components. For example, the absolute value may be greater than or equal to 70% of the largest value in the absolute values of the piezoelectric tensor components.

In some implementable structures, the first piezoelectric layer 301 and the second piezoelectric layer 302 may be two adjacent layers. In some other examples, another piezoelectric layer may alternatively be stacked between the first piezoelectric layer 301 and the second piezoelectric layer 302.

In some examples, the piezoelectric material of the first piezoelectric layer 301 and the piezoelectric material of the second piezoelectric layer 302 may include at least one of a combination of niobium and lithium and a combination of tantalum and lithium. For example, materials of the first piezoelectric layer 301 and the second piezoelectric layer 302 include any one of or any combination of lithium tantalate (LiTaO3), lithium niobate (LiNbO$_3$), aluminum nitride (AlN), and zinc oxide (ZnO).

In this example of this application, under action of the piezoelectric tensor component e$_{34}$, the first piezoelectric layer 301 and the second piezoelectric layer 302 vibrate in an extension direction of the second electrode 40.

In some examples, both the first piezoelectric layer 301 and the second piezoelectric layer 302 include lithium niobate (LiNbO$_3$). When Euler angles of a crystal of the piezoelectric material of the first piezoelectric layer 301 are (0°, 90°, 0°), the piezoelectric tensor component e$_{34}$ of the piezoelectric material of the first piezoelectric layer 301 is +3.696; and when Euler angles of a crystal of the piezoelectric material of the second piezoelectric layer 302 are (0°, 90°, 180°), the piezoelectric tensor component e$_{34}$ of the piezoelectric material of the second piezoelectric layer 302 is -3.696.

In some other examples, both the first piezoelectric layer 301 and the second piezoelectric layer 302 include lithium niobate (LiNbO$_3$). When Euler angles of a crystal of the piezoelectric material of the first piezoelectric layer 301 are (0°, 270°, 0°), the piezoelectric tensor component e$_{34}$ of the piezoelectric material of the first piezoelectric layer 301 is -3.696; and when Euler angles of a crystal of the piezoelectric material of the second piezoelectric layer 302 are (0°, 270°, 180°), the piezoelectric tensor component e$_{34}$ of the piezoelectric material of the second piezoelectric layer 302 is +3.696.

In this example of this application, the Euler angles (0°, 90°, 0°), the Euler angles (0°, 90°, 180°), the Euler angles (0°, 270°, 0°), and the Euler angles (0°, 270°, 180°) may have a specific error range.

For example, the Euler angles may be (0°±5°, 90°±5°, 0°±5°), the Euler angles may be (0°±5°, 90°+£5°, 180°±5°), the Euler angles may be (0°±5°, 270°±5°, 0°±5°), or the Euler angles may be (0°±5°, 270°±5°, 180°±5°).

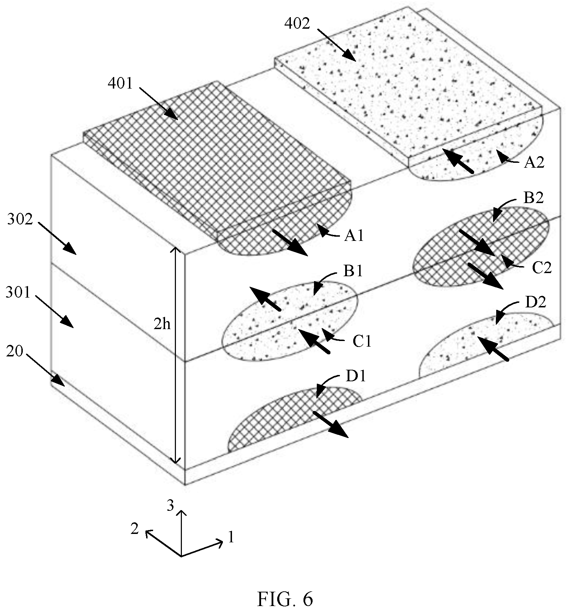

FIG. 6 shows an example of a principle of how to increase an electromechanical coupling factor Kt$^2$ of the structure shown in FIG. 5 in this application.

In FIG. 6, both the first piezoelectric layer 301 and the second piezoelectric layer 302 may be made of lithium niobate (LiNbO$_3$), and vibration directions of the first piezoelectric layer 301 and the second piezoelectric layer 302 are in a direction 2. The first piezoelectric layer 301 is disposed closer to the first electrode 20 than the second piezoelectric layer 302. FIG. 6 shows an example of a second electrode 401 and a second electrode 402 in the second electrodes. Filling patterns in FIG. 6 show general regions in which the resonator vibrates.

For example, when a positive voltage is applied to the second electrode 401, because the first piezoelectric layer 301 and the second piezoelectric layer 302 have the piezoelectric tensor components e$_{34}$ that are opposite to each other, a part (for example, a part A1 in FIG. 6) that is of the second piezoelectric layer 302 and that is close to the second electrode 401 vibrates in a direction opposite to the direction 2, a part (for example, a part B1 in FIG. 6) that is of the second piezoelectric layer 302 and that is close to the first piezoelectric layer 301 vibrates in the direction 2, a part (for example, a part C1 in FIG. 6) that is of the first piezoelectric layer 301 and that is close to the second piezoelectric layer 302 vibrates in the direction 2, and a part (for example, a part D1 in FIG. 6) that is of the first piezoelectric layer 301 and that is close to the first electrode 20 vibrates in the direction opposite to the direction 2.

As shown in FIG. 6, between the second electrode 401 and the first electrode 20 and at a position at which the first piezoelectric layer 301 is attached to the second piezoelectric layer 302, the two vibrations in the direction 2 are coupled, so that a mechanical vibration is generated inside the entire piezoelectric layer.

For another example, when a negative voltage is applied to the second electrode 401, a part (for example, a part A2 in FIG. 6) that is of the second piezoelectric layer 302 and that is close to the second electrode 401 vibrates in the direction 2, a part (for example, a part B2 in FIG. 6) that is of the second piezoelectric layer 302 and that is close to the first piezoelectric layer 301 vibrates in a direction opposite to the direction 2, a part (for example, a part C2 in FIG. 6) that is of the first piezoelectric layer 301 and that is close to the second piezoelectric layer 302 vibrates in the direction opposite to the direction 2, and a part (for example, a part D2 in FIG. 6) that is of the first piezoelectric layer 301 and that is close to the first electrode 20 vibrates in the direction 2.

As shown in FIG. 6, between the second electrode 402 and the first electrode 20 and at a position at which the first piezoelectric layer 301 is attached to the second piezoelectric layer 302, the two vibrations in the direction opposite to the direction 2 are coupled, so that a mechanical vibration is generated inside the entire piezoelectric layer.

Therefore, in the resonator structure shown in FIG. 6 in this example of this application, when piezoelectric tensor components e$_{34}$ of adjacent piezoelectric layers are opposite numbers of each other, coupling resonance is generated at an interface of the multi-layer piezoelectric layer, so that a mechanical vibration is generated inside the entire piezoelectric layer, thereby increasing the electromechanical coupling factor Kt$^2$.

In this example of this application, because there is a spacing between the second electrode 401 and the second electrode 402, compared with a resonator (for example, a film bulk acoustic resonator FBAR) in which a second electrode 401 and a second electrode 402 are connected as a whole, in the resonator in FIG. 6 in this application, the second electrode 401 is not constrained by the second electrode 402, and has a larger degree of freedom. Further, as shown in FIG. 6, the second electrode 402 may also vibrate in the direction 2, to increase a vibration amount of the entire resonator.

Similarly, because there is the spacing between the second electrode 401 and the second electrode 402, compared with the resonator (for example, the film bulk acoustic resonator FBAR) in which the second electrode 401 and the second electrode 402 are connected as the whole, in the resonator in FIG. 6 in this application, the second electrode 402 is not constrained by the second electrode 401 or another second electrode, and the second electrode 402 has a larger degree of freedom. Further, as shown in FIG. 6, the second electrode 402 may also vibrate in the direction 2, to increase the vibration amount of the entire resonator.

In this way, the electromechanical coupling factor $Kt^2$ of the resonator can be further increased.

Polarities of the first piezoelectric layer 301 and the second piezoelectric layer 302 may be opposite. In this way, a vibration amplitude in the piezoelectric layer can be larger, and the electromechanical coupling factor can be further increased.

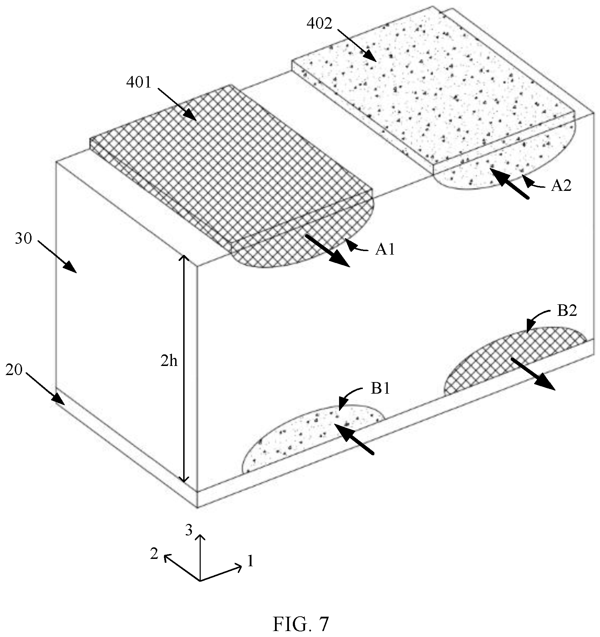

In some possible implementations, as shown in FIG. 6, the first piezoelectric layer 301 may rotate 180° around an axis (a direction 3 in FIG. 7) perpendicular to a plane of the first piezoelectric layer 301, to obtain the second piezoelectric layer 302 whose polarity is opposite to that of the first piezoelectric layer 301. In this case, piezoelectric tensor components $e_{31}$, $e_{32}$, $e_{33}$, $e_{14}$, $e_{24}$, $e_{15}$, $e_{25}$, and $e_{36}$ of the first piezoelectric layer 301 and the second piezoelectric layer are the same, and the other piezoelectric tensor components are opposite numbers of each other. For example, $e_{11}$, $e_{12}$, $e_{13}$, $e_{16}$, $e_{21}$, $e_{22}$, $e_{23}$, $e_{26}$, $e_{34}$ and $e_{35}$ are opposite numbers of each other.

In some other implementations, as shown in FIG. 6, the first piezoelectric layer 301 may rotate 180° around an axis (a direction 1 in FIG. 7) that is parallel to a plane of the first piezoelectric layer 301 and that is perpendicular to the extension direction of the second electrode, to obtain the second piezoelectric layer 302 whose polarity is opposite to that of the first piezoelectric layer 301. In this case, piezoelectric tensor components $e_{11}$, $e_{12}$, $e_{13}$, $e_{14}$, $e_{25}$, $e_{35}$, $e_{26}$, and $e_{36}$ of the first piezoelectric layer 301 and the second piezoelectric layer are the same, and the other piezoelectric tensor components are opposite numbers of each other. For example, $e_{15}$, $e_{16}$, $e_{21}$, $e_{22}$, $e_{23}$, $e_{24}$, $e_{31}$, $e_{32}$, $e_{33}$, and $e_{34}$ are opposite numbers of each other.

FIG. 7 is an example diagram of a vibration in a case in which one piezoelectric layer is used. A part (a part A1 in FIG. 7) that is of the piezoelectric layer 30 and that is attached to the second electrode 401 vibrates in a direction opposite to a direction 2, and a part (a part B1 in FIG. 7) that is of the piezoelectric layer 30 and that is attached to the first electrode 20 vibrates in the direction 2. Compared with FIG. 6, in FIG. 7, a vibration is basically not generated in the entire piezoelectric layer 30. However, in FIG. 6 in this example of this application, a vibration is generated on an upper surface part and a lower surface part of a piezoelectric layer, and a vibration is generated at an interface between adjacent piezoelectric layers. In some scenarios, even if a vibration of a part that is of the piezoelectric layer and that is attached to the first electrode 20 is limited, the resonator in this example of this application can still increase the electromechanical coupling factor $Kt^2$.

Through comparison between FIG. 6 and FIG. 7, a sum 2h of thickness dimensions of the first piezoelectric layer 301 and the second piezoelectric layer 302 in FIG. 6 is basically equal to or approximately equal to a thickness dimension of the piezoelectric layer 30 in FIG. 7, and a resonance frequency in FIG. 6 is basically the same as or approximately the same as a resonance frequency in FIG. 7.

The resonator in FIG. 6 in this example of this application can further increase the electromechanical coupling factor $Kt^2$ while ensuring that the resonance frequency meets a requirement.

The direction 2 in this embodiment of this application may be understood as being parallel to the extension direction of the second electrode 40. The direction 3 may be understood as a direction perpendicular to a surface of the substrate 10, or a direction parallel to a direction in which the first piezoelectric layer 301 and the second piezoelectric layer 302 are stacked. The direction 1 may be understood as being parallel to the surface of the substrate 10 and perpendicular to the extension direction of the second electrode 40.

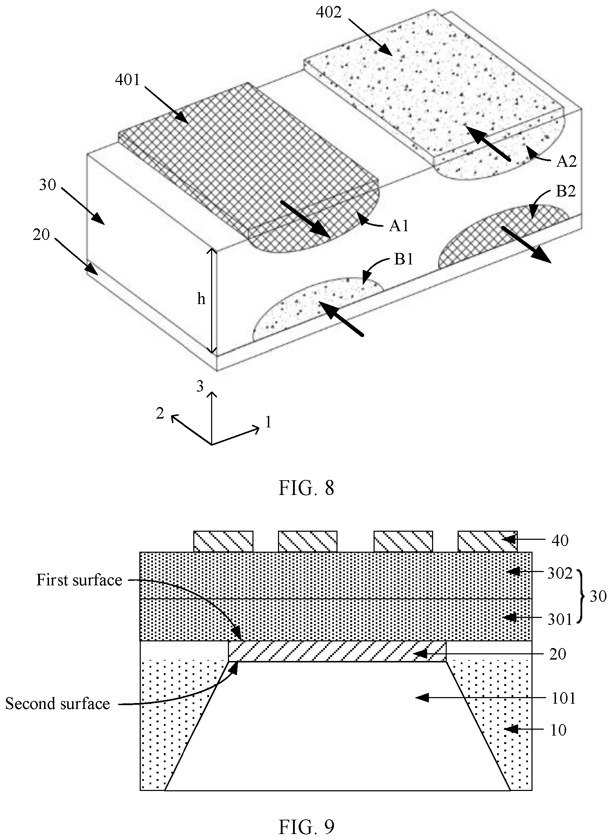

In some examples, to increase a resonance frequency, a resonator shown in FIG. 8 may also be used. Through comparison between FIG. 8 and FIG. 7, a thickness dimension of a piezoelectric layer 30 with a one-layer structure in FIG. 8 is h, and a thickness dimension of the piezoelectric layer 30 with a one-layer structure in FIG. 7 is 2h. For example, the resonance frequency may be f in FIG. 7, and the resonance frequency may be 2f in FIG. 8. In other words, the resonance frequency of the resonator can be increased by reducing the thickness dimension of the piezoelectric layer 30. However, in a process, when the resonance frequency is increased by reducing the thickness dimension of the piezoelectric layer 30, a large challenge may be posed to a photolithography technology. As a result, the increase of the resonance frequency is limited to some extent, and high-frequency application of the resonators shown in FIG. 7 and FIG. 8 is limited.

However, when the resonator shown in FIG. 6 is used, a limitation of the photolithography technology is mitigated by stacking of the multi-layer piezoelectric layer. Therefore, the resonator is applicable to a high-frequency range while stability and firmness of the resonator are improved.

FIG. 9 is a diagram of a process structure of another resonator according to an example of this application. In the resonator, a cavity 101 is disposed in a substrate 10. The resonator may be referred to as a suspended cavity piezoelectric thin-film resonator.

In FIG. 9, a second electrode 20 has a first surface and a second surface that face away from each other. The first surface is closer to a piezoelectric layer 30 than the second surface. The substrate 10 is provided with the cavity 101. At least a part of the second surface of the first electrode 20 is used to enclose the cavity 101, and at least a part of the first electrode 20 is disposed between the cavity 101 and the piezoelectric layer 30.

In this example, the piezoelectric layer 30 may also include a plurality of stacked layers, for example, include a first piezoelectric layer 301 and a second piezoelectric layer 302 that are stacked. In the multi-layer piezoelectric layer, adjacent piezoelectric layers have piezoelectric tensor components that are opposite to each other. For example, a piezoelectric tensor component $e_{34}$ of the first piezoelectric layer 301 is opposite to a piezoelectric tensor component $e_{34}$ of the second piezoelectric layer 302.

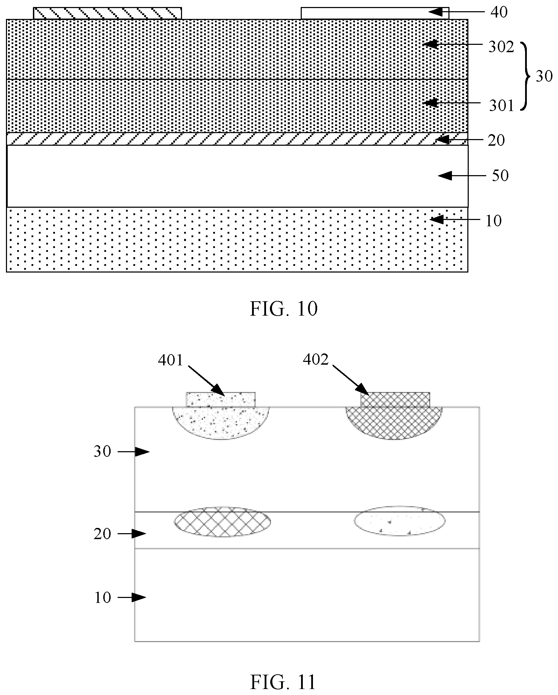

FIG. 10 is a diagram of a process structure of another resonator according to an embodiment of this application. In this example, a dielectric layer 50 is further included, and the dielectric layer 50 is stacked between a substrate 10 and a first electrode 20. For example, the dielectric layer 50 may be silicon oxide ($SiO_2$).

In some examples, a thickness g of the dielectric layer 50 satisfies: $g=\lambda/4$, where $\lambda$ is a wavelength of an acoustic wave of the resonator at a resonance frequency in a material of the dielectric layer 50.

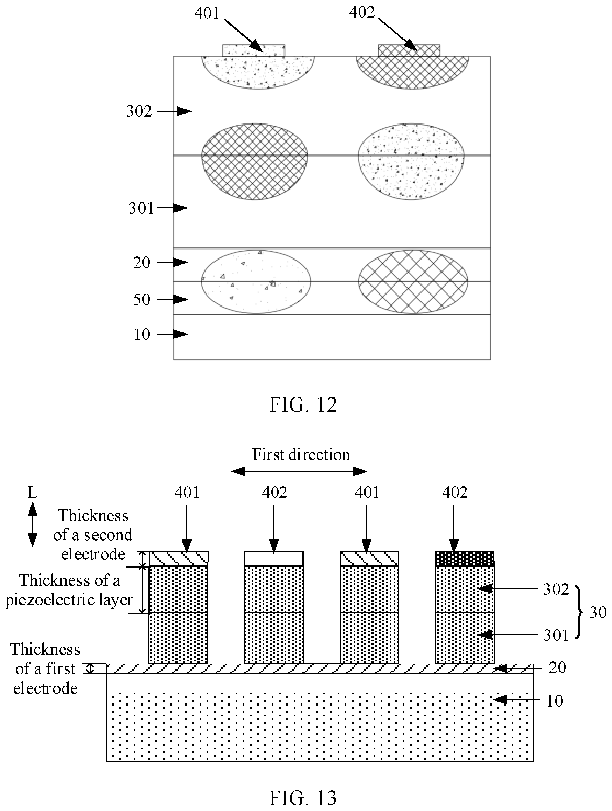

As shown in FIG. 11 and FIG. 12, in FIG. 11, a piezoelectric layer 30 includes one piezoelectric layer; and in FIG. 12, a piezoelectric layer 30 includes a first piezoelectric layer 301 and a second piezoelectric layer 302 that are stacked, and a dielectric layer 50 stacked between a substrate 10 and a first electrode 20 is further included.

In FIG. 11, because a first electrode 20 of a metal layer is directly stacked on a substrate 10, vibration amplitudes of the piezoelectric layer 30 and the first electrode 20 are limited. As shown in FIG. 11, a vibration region and a vibration amplitude are very small. However, as shown in FIG. 12, because a dielectric layer with low hardness is stacked between the substrate 10 and the first electrode 20, compared with FIG. 11, in FIG. 12, a mechanical vibration is also generated in the first electrode 20 and the dielectric layer 50, thereby increasing a vibration amount of the entire resonator, and increasing an electromechanical coupling factor $Kt^2$.

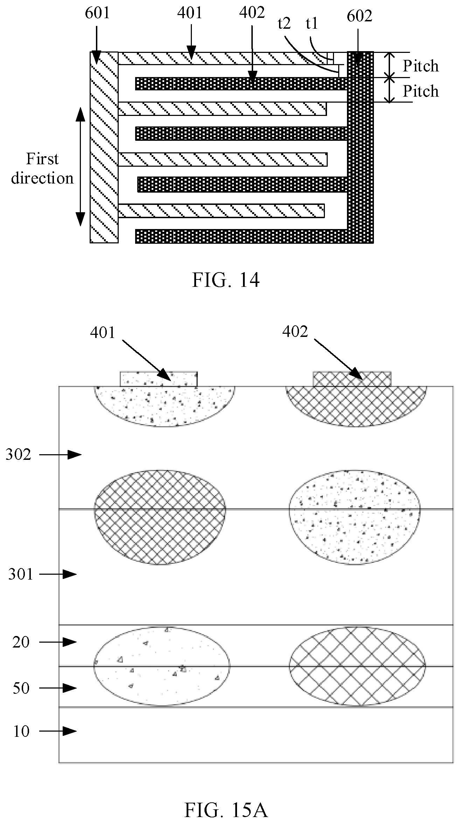

FIG. 13 is a diagram of a process structure of a resonator according to an embodiment of this application. FIG. 14 is a diagram of distribution of second electrodes in FIG. 13.

In resonators shown in FIG. 13 and FIG. 14, the plurality of second electrodes include a plurality of first interdigital electrodes 401 and a plurality of second interdigital electrodes 402. For example, in a direction perpendicular to an extension direction of the first interdigital electrode 401, the plurality of first interdigital electrodes 401 and the plurality of second interdigital electrodes 402 may be disposed side by side, and the plurality of first interdigital electrodes 401 and the plurality of second interdigital electrodes 402 are spaced from each other, that is, one second interdigital electrode 402 may be disposed between two adjacent first interdigital electrodes 401. Alternatively, the first interdigital electrode 401 and the second interdigital electrode 402 are spaced from each other in a first direction, and an extension direction of the first interdigital electrode 401 and/or the second interdigital electrode 402 is perpendicular to the first direction.

The plurality of first interdigital electrodes 401 are connected to each other through a first busbar 601, and the plurality of second interdigital electrodes 402 are connected to each other through a second busbar 602. For example, the first busbar 601 and the second busbar 602 are disposed in parallel, and both the first busbar 601 and the second busbar 602 extend in a direction perpendicular to the extension direction of the first interdigital electrode 401 or the second interdigital electrode 402. As shown in FIG. 14, the first busbar 601 and the second busbar 602 extend in the first direction.

A pitch (Pitch) P may be understood as follows: In FIG. 12, a width of each first interdigital electrode 401 is t1, a spacing between each first interdigital electrode 401 and each second interdigital electrode 402 that are adjacent to each other is t2, and the pitch (Pitch) P is a sum of the width t1 and the spacing t2.

In some examples, the width dimension t1 of each of the plurality of first interdigital electrodes 401 has a process tolerance, and the spacing t2 between each first interdigital electrode 401 and each second interdigital electrode 402 that are adjacent to each other also has a process tolerance.

A thickness of a piezoelectric layer, a thickness of a first electrode, and a thickness of the second electrode are respectively a height dimension of the piezoelectric layer, a height dimension of the first electrode, and a height dimension of the second electrode in a direction (for example, a direction L in FIG. 13) in which a plurality of film layer structures are stacked.

A metallization ratio is a ratio of the width s1 of the first interdigital electrode 401 to the pitch P, or a ratio of a width of the second interdigital electrode 402 to the pitch. In some examples, the width of the first interdigital electrode 401 is equal to the width of the second interdigital electrode 402.

When the resonator operates, an acoustic loss may be generated at an electrode, and operating performance of the device is reduced. For example, an acoustic loss may be generated at the first electrode 20 or the second electrode 40. To reduce the acoustic loss at the electrode, in some examples, a thickness dimension of the electrode may be reduced. However, when the thickness dimension of the electrode is reduced, a power tolerance capability of the electrode is weakened, and a service life of the device is shortened.

In the resonator in this example of this application, a plurality of stacked piezoelectric layers are used to increase a thickness dimension of the entire piezoelectric layer, so that a ratio of a thickness dimension of an electrode layer to the thickness dimension of the entire piezoelectric layer can be reduced. A thick piezoelectric layer is used to reduce the acoustic loss at the electrode. In this way, the power tolerance capability of the electrode can be further ensured.

In some examples, as shown in FIG. 13, the thickness dimension of the second electrode layer 40 is S1, and a sum of thickness dimensions of a first piezoelectric layer and a second piezoelectric layer is S2, where $S1/S2 \leq 0.35$.

For example, $\dfrac{S1}{S2} \le 0.3$ . For another example, $\dfrac{S1}{S2} \le 0.2$ . For another example, $\dfrac{S1}{S2} \le 0.1$ .

In some examples, a thickness dimension of the first electrode is S3, and a sum of thickness dimensions of a first piezoelectric layer and a second piezoelectric layer is S2, where $\dfrac{S3}{S2} \le 0.35$ . For example, $\dfrac{S3}{S2} \le 0.3$ . For another example, $\dfrac{S3}{S2} \le 0.2$ . For another example, $\dfrac{S3}{S2} \le 0.1$ .

To increase a resonance frequency of the resonator, in some examples, a pitch shown in FIG. 14 may be reduced. However, when the pitch is reduced, a challenge is posed to a photolithography technology. In this example of this application, the pitch P and the thickness dimension of the piezoelectric layer 30 may satisfy: P/d>1.

In some examples, the resonance frequency of the resonator may be greater than or equal to 3.64 GHz, for example, may reach 4.34 GHz.

With reference to accompanying drawings and table data, the following compares the resonator provided in embodiments of this application and a resonator in a related technology about an electromechanical coupling factor and how to suppress a parasitic spurious mode.

FIG. 15A is a diagram of a process structure of a resonator according to an embodiment of this application. FIG. 15A shows a vibration in a direction 2.

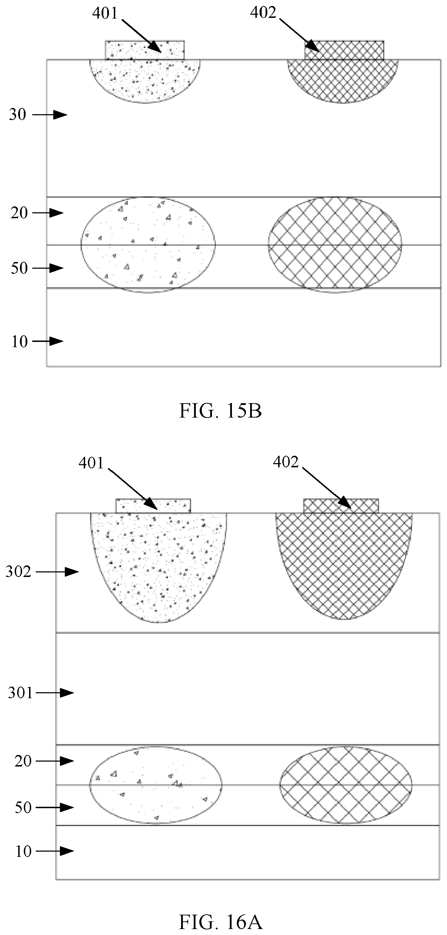

FIG. 15B is a diagram of a process structure of a resonator having one piezoelectric layer. FIG. 15B shows a vibration in a direction 2.

As shown in FIG. 15A, there are vibrations in the direction 2 at positions that are of a second piezoelectric layer 302 and that are attached to a second electrode 401 and a second electrode 402, there is a vibration in the direction 2 at an interface between the second piezoelectric layer 302 and a first piezoelectric layer 301, and there is a slight vibration in the direction 2 at an interface between a dielectric layer 50 and a first electrode 20. A main resonance mode SH1 of the resonator is generated in the direction 2, in other words, a vibration direction of the main resonance mode SH1 of the resonator is the direction 2 parallel to an extension direction of a second electrode 40.

As shown in FIG. 15B, there are vibrations in the direction 2 at positions that are of a piezoelectric layer 30 and that are attached to a second electrode 401 and a second electrode 402, and there is a slight vibration in the direction 2 at an interface between a dielectric layer 50 and a first electrode 20. In the resonator, a main resonance mode SH1 of the resonator is generated in the direction 2, in other words, a vibration direction of the main resonance mode SH1 of the resonator is the direction 2 parallel to an extension direction of a second electrode 40.

Through comparison between FIG. 15A and FIG. 15B, in FIG. 15A in this example of this application, coupling resonance is generated inside the entire piezoelectric layer.

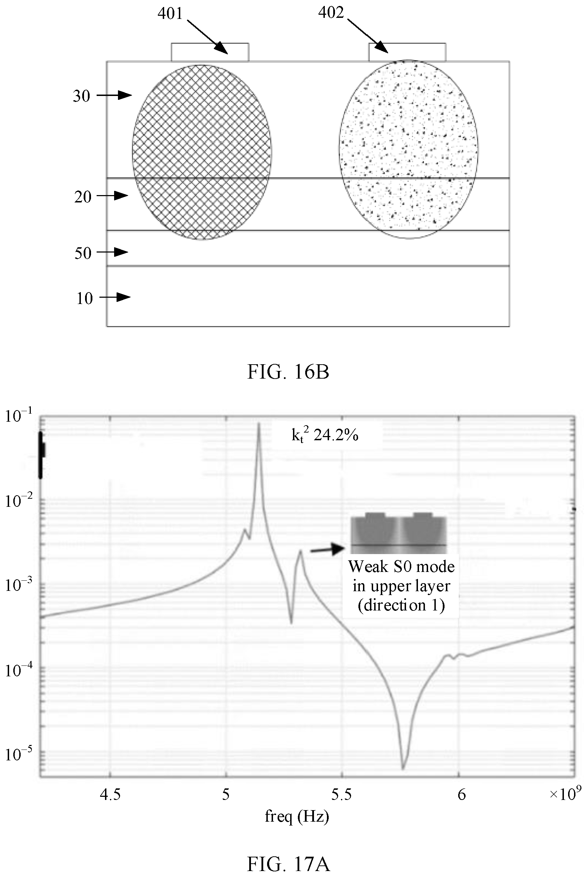

FIG. 16A shows a vibration of the resonator shown in FIG. 15A in a direction 1. FIG. 16B shows a vibration of the resonator shown in FIG. 15B in a direction 1.

In the diagram of the vibration in the direction 1 shown in FIG. 16A, there are vibrations in the direction 1 at positions that are of the second piezoelectric layer 302 and that are attached to the second electrode 401 and the second electrode 402, and there is a slight vibration in the direction 1 at an interface between the dielectric layer 50 and the first electrode 20. A parasitic mode S0 of the resonator is generated in the direction 1.

In the diagram of the vibration in the direction 1 shown in FIG. 16B, there is a vibration in the direction 1 inside the entire piezoelectric layer 30, there is a vibration in the direction 1 at an interface between the piezoelectric layer 30 and the first electrode 20, and there is a vibration in the direction 1 inside the first electrode 20. A parasitic mode S0 of the resonator is generated in the direction 1.

Through comparison between FIG. 16A and FIG. 16B, in FIG. 16B, a vibration area in which a parasitic spurious mode S0 is generated is large, and in FIG. 16A, a vibration area in which a parasitic spurious mode S0 is generated is small.

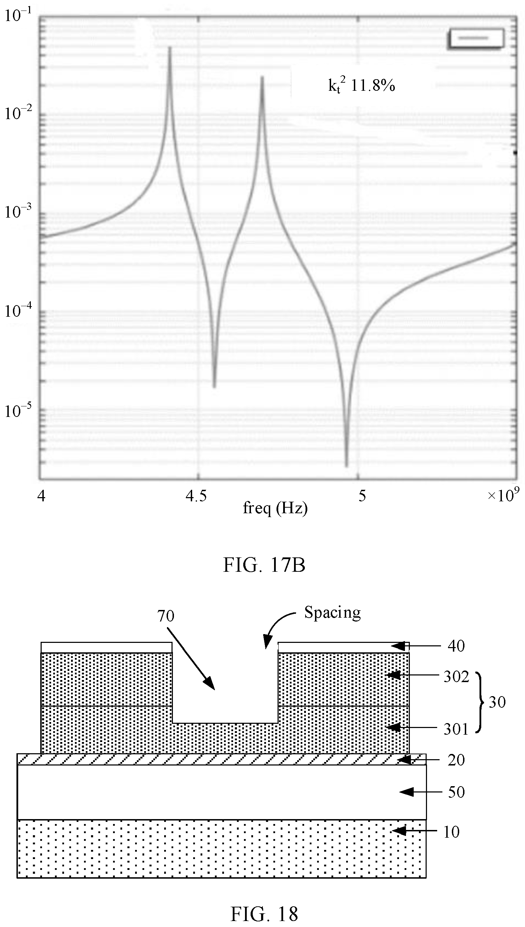

FIG. 17A shows an admittance simulation curve obtained by using the structure shown in FIG. 15A and physical parameter limitations shown in Table 1. FIG. 17B shows an admittance simulation curve obtained by using the structure shown in FIG. 15B and physical parameter limitations shown in Table 2.

Table 1

| | |
|---|---|
| Pitch | 0.6 $\mu$m |
| Metallization ratio | 0.45 |
| Thickness of a second electrode | 50 nm |
| Thickness of a first piezoelectric layer | 360 nm |
| Thickness of a second piezoelectric layer | 360 nm |
| Euler angles of a material of the first piezoelectric layer | (90°, 90°, 210°) |
| Euler angles of a material of the second piezoelectric layer | (90°, 90°, 30°) |

(continued)

| Thickness of a first electrode | 120 nm |
|---|---|
| Thickness of a dielectric layer | 120 nm |

Table 2

| Pitch | 0.6 $\mu$m |
|---|---|
| Metallization ratio | 0.45 |
| Thickness of a second electrode | 50 nm |
| Thickness of a piezoelectric layer | 360 nm |
| Euler angles of a material of the piezoelectric layer | (90°, 90°, 30°) |
| Thickness of a first electrode | 120 nm |
| Thickness of a dielectric layer | 120 nm |

Through comparison between Table 1 and Table 2, in the physical parameters of the two resonators with different structures, the pitches P are equal, the metallization ratios are equal, the thicknesses of the second electrodes are equal, the thicknesses of the first electrodes are equal, and the thicknesses of the dielectric layers are equal. Because the Euler angles of the materials of the two piezoelectric layers in Table 1 rotate 180°, piezoelectric polarization directions of the first piezoelectric layer and the second piezoelectric layer are opposite.

In the resonator provided in this application shown in FIG. 17A, a small S0 longitudinal-wave spurious mode is excited near a resonance point of the main resonance mode SH1. However, in an admittance curve shown in FIG. 17B, a large S0 longitudinal-wave spurious mode is excited near a resonance point of the main resonance mode SH1.

In addition, as shown in FIG. 17A, in the resonator in this example of this application, an electromechanical coupling factor $Kt^2$ reaches 24.2%. However, in the resonator having one piezoelectric layer, as shown in FIG. 17B, an electromechanical coupling factor $Kt^2$ is 11.8%. It is obvious that the resonator having a multi-layer piezoelectric layer provided in this embodiment of this application can increase the electromechanical coupling factor $Kt^2$. For example, the electromechanical coupling factor $Kt^2$ may be greater than or equal to 20%.

Compared with a resonance frequency of the resonator in FIG. 15B, a resonance frequency of the resonator in FIG. 15A in this example of this application is increased from 4.7 GHz to 5.1 GHz.

In this way, the resonator including at least two piezoelectric layers in this example of this application can increase the electromechanical coupling factor, increase the resonance frequency, suppress the parasitic spurious mode, and further optimize performance of the resonator.

FIG. 18, FIG. 19, and FIG. 20 are diagrams of process structures of three other resonators according to an embodiment of this application. In this example, a groove 70 is further disposed in the resonator, there is a spacing between two adjacent second electrodes 40, the groove 70 is disposed in a piezoelectric layer 30, and the groove 70 is opposite to the spacing. In other words, it may be understood that the groove 70 penetrates the spacing.

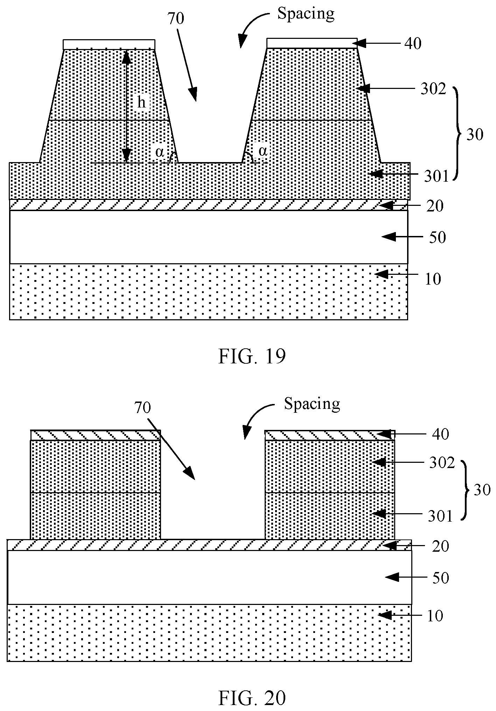

In some examples, as shown in FIG. 18 and FIG. 19, a first piezoelectric layer 301 is closer to a substrate 10 than a second piezoelectric layer 302, and the groove 70 may penetrate the second piezoelectric layer 302 and a part of the first piezoelectric layer 301. In some other examples, as shown in FIG. 20, the groove 70 may penetrate the second piezoelectric layer 302 and the first piezoelectric layer 301 until a surface of a first electrode 20.

That is, it may be understood that, in this example of this application, the groove 70 may penetrate a part of the piezoelectric layer 30, or may penetrate the entire piezoelectric layer 30 until the surface of the first electrode 20.

The groove is disposed in a multi-layer piezoelectric layer, to reduce a limitation on the piezoelectric layer, and further increase an electromechanical coupling factor $Kt^2$ of the resonator. In addition, the groove 70 further helps suppress or frequency-shift a parasitic mode.

In some implementation structures, a deeper groove 70 indicates a larger electromechanical coupling factor $Kt^2$ of the resonator. In this embodiment of this application, as shown in FIG. 11, a depth h of the groove 70 may satisfy: 30% H≤h≤H, where H is a thickness dimension of the piezoelectric layer 30. For example, h=50%H, h=60%H, h=70%H, h=80% H, h=90%H, or h=H.

In addition, in some implementable examples, a radial dimension of the groove 70 is gradually decreased in a direction from a top surface to a bottom surface of the groove 70. For example, as shown in FIG. 19, a tilt angle $\alpha$ of the groove 70 may be: 45°≤$\alpha$≤90°. For example, in FIG. 19, the tilt angle $\alpha$ is about 60°, and in FIG. 18 and FIG. 20, the tilt angle $\alpha$ is about 90°.

The tilt angle $\alpha$ of the groove 70 may be understood as an included angle between a side surface of the groove 70 and a reference plane, and the reference plane is a plane parallel to the surface of the substrate 10.

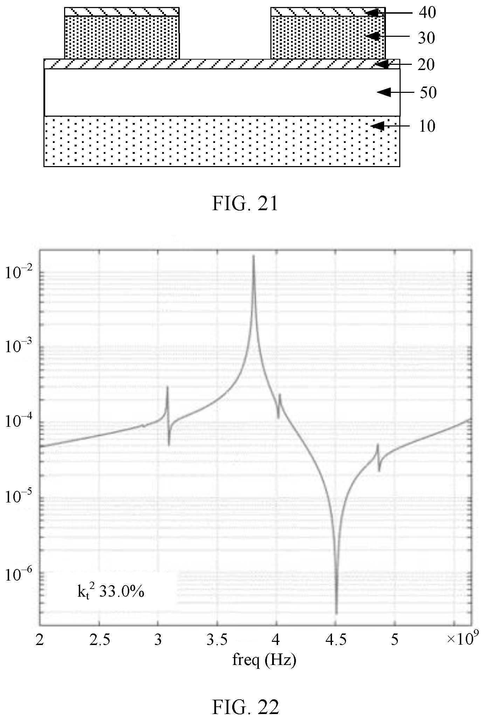

FIG. 21 is a diagram of a process structure of a resonator having one piezoelectric layer 30. Same as these in FIG.

18 and FIG. 20 in this example of this application, a groove 70 is further disposed in the resonator, there is a spacing between two adjacent second electrodes 40, the groove 70 is disposed in the piezoelectric layer 30, and the groove 70 penetrates the spacing.

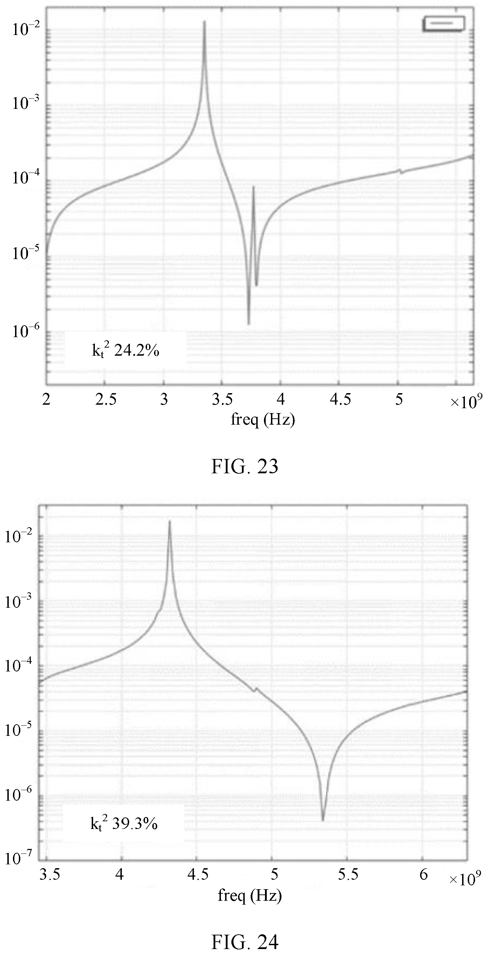

FIG. 22 shows an admittance simulation curve obtained by using the structure in FIG. 20 and physical parameter limitations shown in Table 3. FIG. 23 shows an admittance simulation curve obtained by using the structure in FIG. 21 and physical parameter limitations shown in Table 4.

Table 3

| | |
|---|---|
| Pitch | 0.6 $\mu$m |
| Metallization ratio | 0.5 |
| Thickness of a second electrode | 100 nm |
| Thickness of a first piezoelectric layer | 350 nm |
| Thickness of a second piezoelectric layer | 350 nm |
| Euler angles of a material of the first piezoelectric layer | (90°, 90°, 210°) |
| Euler angles of a material of the second piezoelectric layer | (90°, 90°, 30°) |
| Thickness of a first electrode | 250 nm |
| Thickness of a dielectric layer | 175 nm |

Table 4

| | |
|---|---|
| Pitch | 0.6 $\mu$m |
| Metallization ratio | 0.5 |
| Thickness of a second electrode | 100 nm |
| Thickness of a piezoelectric layer | 350 nm |
| Euler angles of a material of the piezoelectric layer | (90°, 90°, 30°) |
| Thickness of a first electrode | 250 nm |
| Thickness of a dielectric layer | 175 nm |

When the parameters in the foregoing tables are used, a frequency band range of the resonator shown in FIG. 20 and a frequency band range of the resonator shown in FIG. 21 may be N77.

Through comparison between the admittance simulation curve in FIG. 22 and the admittance simulation curve in FIG. 23, it may be seen that when the resonator in FIG. 20 in this example of this application is used, an electromechanical coupling factor $Kt^2$ reaches 33.0%, and when the piezoelectric layer shown in FIG. 21 is used, an electromechanical coupling factor $Kt^2$ is 24.2%. It is obvious that when the groove is disposed in the piezoelectric layer and a plurality of piezoelectric layers with opposite polarities are included, the electromechanical coupling factor $Kt^2$ can be increased.

Compared with a resonance frequency of the resonator in FIG. 21, a resonance frequency of the resonator in FIG. 20 in this example of this application is increased from 3.35 GHz to 3.81 GHz.

Still as shown in FIG. 22, in the admittance simulation curve, near a resonance point of a main resonance mode SH1 and near an anti-resonance point of the main resonance mode SH1, an S0 longitudinal-wave spurious mode is effectively suppressed. In the resonator admittance simulation curve shown in FIG. 23, near a resonance point of a main resonance mode SH1 and near an anti-resonance point of the main resonance mode SH1, a large S0 longitudinal-wave spurious mode is excited.

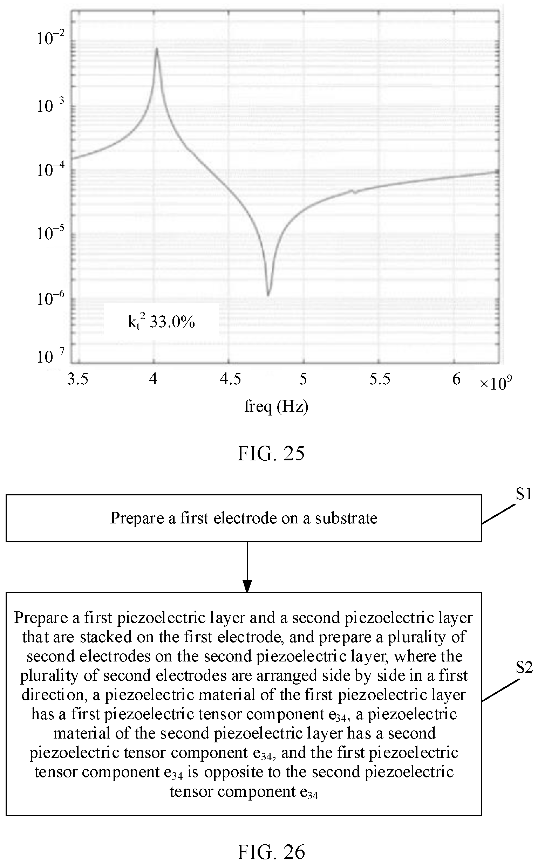

FIG. 24 shows an admittance simulation curve obtained by using the structure in FIG. 20 and physical parameter limitations shown in Table 5. FIG. 25 shows an admittance simulation curve obtained by using the structure in FIG. 21 and physical parameter limitations shown in Table 6.

Table 5

| | |
|---|---|
| Pitch | 0.6 $\mu$m |
| Metallization ratio | 0.5 |
| Thickness of a second electrode | 75 nm |
| Thickness of a first piezoelectric layer | 360 nm |
| Thickness of a second piezoelectric layer | 360 nm |
| Euler angles of a material of the first piezoelectric layer | (90°, 90°, 210°) |
| Euler angles of a material of the second piezoelectric layer | (90°, 90°, 30°) |

(continued)

| Thickness of a first electrode | 40 nm |
|---|---|
| Thickness of a dielectric layer | 180 nm |

Table 6

| Pitch | 0.6 $\mu$m |
|---|---|
| Metallization ratio | 0.5 |
| Thickness of a second electrode | 75 nm |
| Thickness of a piezoelectric layer | 360 nm |
| Euler angles of a material of the piezoelectric layer | (90°, 90°, 30°) |
| Thickness of a first electrode | 40 nm |
| Thickness of a dielectric layer | 180 nm |

When the parameters in the foregoing tables are used, a frequency band range of the resonator shown in FIG. 20 and a frequency band range of the resonator shown in FIG. 21 may be N79.

Through comparison between the admittance simulation curve in FIG. 24 and the admittance simulation curve in FIG. 25, it may be seen that when the resonator in FIG. 20 in this example of this application is used, an electromechanical coupling factor $Kt^2$ reaches 39.3%, and when the piezoelectric layer shown in FIG. 21 is used, an electromechanical coupling factor $Kt^2$ is 33.0%. It is obvious that when the groove is disposed in the piezoelectric layer and a plurality of piezoelectric layers with opposite polarities are included, the electromechanical coupling factor $Kt^2$ can be increased.

Compared with a resonance frequency of the resonator in FIG. 21, a resonance frequency of the resonator in FIG. 20 in this example of this application is increased from 4.02 GHz to 4.32 GHz.

An embodiment of this application further provides a preparation method for a resonator including a multi-layer piezoelectric layer. FIG. 26 is an example flowchart of a preparation method for a resonator.

The preparation method includes:

Step S1: Prepare a first electrode on a substrate.

Step S2: Prepare a first piezoelectric layer and a second piezoelectric layer that are stacked on the first electrode, and prepare a plurality of second electrodes on the second piezoelectric layer, where the plurality of second electrodes are arranged side by side in a first direction, a piezoelectric material of the first piezoelectric layer has a first piezoelectric tensor component $e_{34}$, a piezoelectric material of the second piezoelectric layer has a second piezoelectric tensor component $e_{34}$, and the first piezoelectric tensor component $e_{34}$ is opposite to the second piezoelectric tensor component $e_{34}$.

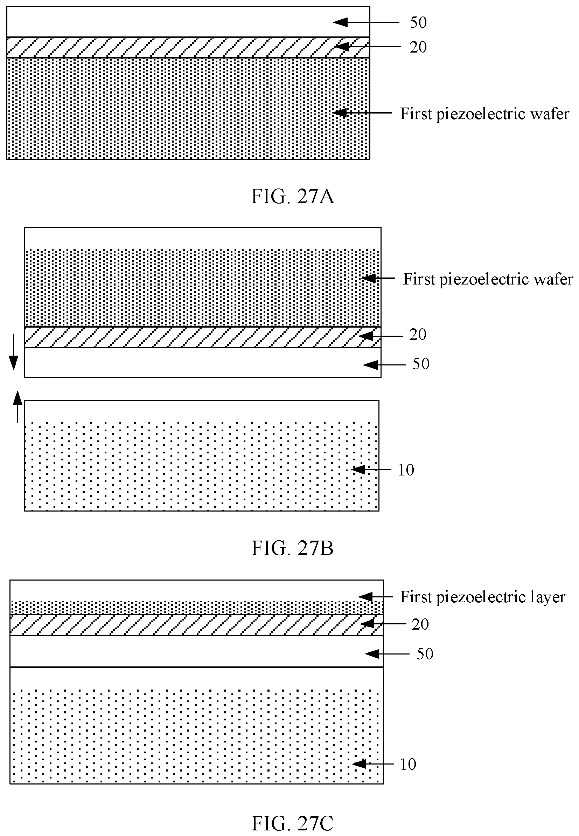

FIG. 27A to FIG. 27F are diagrams of process structures corresponding to steps during preparation of a solid-state substrate piezoelectric thin-film resonator.

As shown in FIG. 27A, the first electrode 20 is prepared on a side of a first piezoelectric wafer, and a dielectric layer 50 is prepared on the first electrode 20.

As shown in FIG. 27B, the first piezoelectric wafer that includes the first electrode 20 and the dielectric layer 50 is bonded to the substrate 10.

As shown in FIG. 27C, the first piezoelectric wafer may be thinned to a target thickness by using an ion implantation cutting (ion implantation cutting) or chemical-mechanical polishing (Chemical-mechanical polishing, CMP) method, to form the first piezoelectric layer.

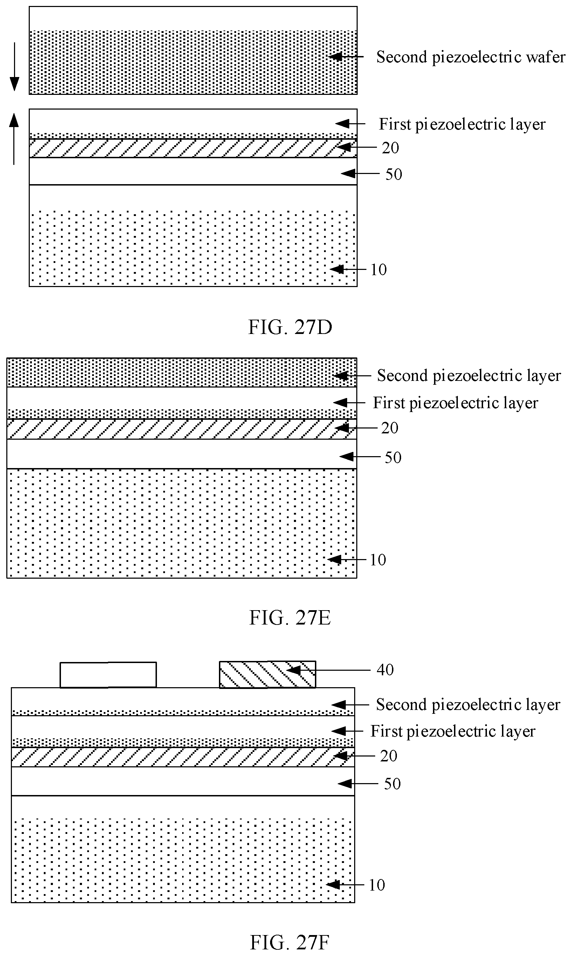

As shown in FIG. 27D, a second piezoelectric wafer is bonded to the first piezoelectric layer in FIG. 27C.

As shown in FIG. 27E, the second piezoelectric wafer may be thinned to a target thickness by using an ion implantation cutting (ion implantation cutting) or chemical-mechanical polishing (Chemical-mechanical polishing, CMP) method, to form the second piezoelectric layer.

As shown in FIG. 27F, the plurality of second electrodes that are disposed side by side are prepared on the second piezoelectric layer. In this way, the solid-state substrate piezoelectric thin-film resonator is prepared.

The first electrode may be any possible conductive metal (including but not limited to Al, Cu, W, Mo, Ru, and Pt), or may be a conductive metal with high acoustic impedance (including but not limited to W, Ru, Mo, and Pt). These metals with high acoustic impedance help increase an electromechanical coupling factor and a quality factor Q, and further improve use performance of the resonator.

The second electrode may be any possible conductive metal (including but not limited to Al, Cu, W, Mo, Ru, and Pt). The first electrode 20 and the second electrode 40 may be a same conductive metal or different conductive metals.

The materials of the first piezoelectric layer and the second piezoelectric layer include at least one of a combination of niobium and lithium and a combination of tantalum and lithium.

In some examples, more piezoelectric layers may also be prepared.

In some other examples, a groove may be disposed at a position corresponding to a gap that is in the piezoelectric layer and that is between two adjacent second electrodes. The groove may penetrate the entire piezoelectric layer, or may penetrate a part of the piezoelectric layer. The groove is used to increase the electromechanical coupling factor or suppress a parasitic spurious mode.

The solid-state substrate piezoelectric thin-film resonator or a suspended cavity piezoelectric thin-film resonator may be used as a sensor, for example, may be a temperature sensor, a humidity sensor, or a pressure sensor. Alternatively, the resonator may be used for processing of various high-frequency signals at 100 MHz to 30 GHz or the like as a delay-line device.

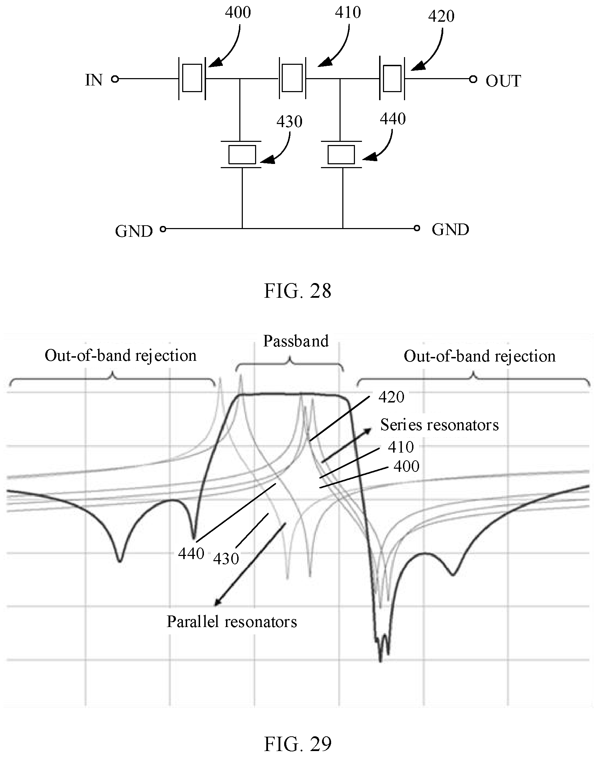

In addition, the suspended cavity piezoelectric thin-film resonator or the solid-state substrate piezoelectric thin-film resonator may be electrically connected in a trapezoidal structure, as shown in FIG. 28, to implement a filter for radio frequency communication. The filter may include resonators connected in series and resonators connected in parallel. A resonance frequency of a parallel resonator may be less than a resonance frequency of a series resonator.

In the example in FIG. 28, a resonator 400, a resonator 410, a resonator 420, a resonator 430, and a resonator 440 are included. The resonator 400, the resonator 410, and the resonator 420 are series resonators, and the resonator 430 and the resonator 440 are parallel resonators. At least one of the resonator 400 to the resonator 440 may be the resonator in the foregoing embodiment.

In some examples, FIG. 29 shows a relationship between an admittance curve of each resonator in the trapezoidal filter in FIG. 28 and a transmission loss curve of the filter. As shown in FIG. 29, resonance points of the series resonators (for example, the resonator 400, the resonator 410, and the resonator 420) and anti-resonance points of the parallel resonators (for example, the resonator 430 and the resonator 440) fall within a passband frequency band, to form a passband of the filter. Anti-resonance points of the series resonators (for example, the resonator 400, the resonator 410, and the resonator 420) fall on a high-frequency side outside the passband, and resonance points of the parallel resonators (for example, the resonator 430 and the resonator 440) fall on a low-frequency side outside the passband. In this way, the filter is characterized by high roll-off and high out-of-band rejection.

In the descriptions of this specification, the specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A resonator, comprising:

    a substrate; and
    a first electrode, a multi-layer piezoelectric layer, and a plurality of second electrodes, wherein the first electrode, the multi-layer piezoelectric layer, and the plurality of second electrodes are disposed on the substrate, the multi-layer piezoelectric layer has a first side and a second side, the plurality of second electrodes are located on the first side and are arranged side by side in a first direction, the first electrode is located on the second side, the first side faces away from the substrate, and the second side faces toward the substrate;
    the multi-layer piezoelectric layer comprises a first piezoelectric layer and a second piezoelectric layer that are stacked; and
    a piezoelectric material of the first piezoelectric layer has a first piezoelectric tensor component $e_{34}$, a piezoelectric material of the second piezoelectric layer has a second piezoelectric tensor component $e_{34}$, and the first piezoelectric tensor component $e_{34}$ is opposite to the second piezoelectric tensor component $e_{34}$.

2. The resonator according to claim 1, wherein there is a spacing between two adjacent second electrodes; and a groove is disposed at a position that is of the multi-layer piezoelectric layer and that is opposite to the spacing, and the groove penetrates the spacing.

3. The resonator according to claim 2, wherein a thickness dimension of the multi-layer piezoelectric layer is H, a depth dimension of the groove is h, and 30% $H \leq h \leq H$.

4. The resonator according to claim 2 or 3, wherein the first piezoelectric layer is disposed closer to the substrate than the second piezoelectric layer; and
the second piezoelectric layer has a top surface facing away from the first piezoelectric layer, the first piezoelectric layer has a bottom surface facing away from the second piezoelectric layer, and the groove penetrates the top surface and the bottom surface.

5. The resonator according to any one of claims 1 to 4, wherein a thickness dimension of the second electrode is S1, the thickness dimension of the multi-layer piezoelectric layer is H, and $S1/H \leq 0.35$.

6. The resonator according to any one of claims 1 to 5, wherein a thickness dimension of the first electrode is S2, the thickness dimension of the multi-layer piezoelectric layer is H, and $S2/H \leq 0.35$.

7. The resonator according to any one of claims 1 to 6, wherein the resonator further comprises a first busbar and a second busbar;

in every two adjacent second electrodes in the plurality of second electrodes, one second electrode is a first interdigital electrode, and the other second electrode is a second interdigital electrode; and the first interdigital electrode and the second interdigital electrode are spaced from each other in the first direction;
a plurality of first interdigital electrodes in the plurality of second electrodes are connected to each other through the first busbar, and a plurality of second interdigital electrodes in the plurality of second electrodes are connected to each other through the second busbar;
a pitch P and the thickness dimension H of the multi-layer piezoelectric layer satisfy: $P/H \geq 1$; and
a width dimension of each first interdigital electrode is t1, a spacing between each first interdigital electrode and each second interdigital electrode that are adjacent to each other is t2, the pitch P is equal to t1+t2, and the width dimension is a dimension that is parallel to a surface of the substrate and that is perpendicular to an extension direction of the first interdigital electrode.

8. The resonator according to any one of claims 1 to 7, wherein
based on a voltage being applied to the plurality of second electrodes, the resonator is configured to excite the multi-layer piezoelectric layer to generate a first resonance mode, wherein a vibration direction of the first resonance mode is parallel to an extension direction of the second electrode.

9. The resonator according to any one of claims 1 to 8, wherein an electromechanical coupling factor $Kt^2$ of the resonator is greater than or equal to 24%.

10. The resonator according to any one of claims 1 to 9, wherein the piezoelectric materials of the first piezoelectric layer and the second piezoelectric layer comprise at least one of a combination of niobium and lithium and a combination of tantalum and lithium.

11. The resonator according to any one of claims 1 to 10, wherein the first electrode a first surface and a second surface that face away from each other, the second surface is closer to the substrate than the first surface, and the second surface of the first electrode is completely disposed on the substrate.

12. The resonator according to any one of claims 1 to 11, wherein

piezoelectric tensor components $e_{31}$, $e_{32}$, $e_{33}$, $e_{14}$, $e_{24}$, $e_{15}$, $e_{25}$, and $e_{36}$ of the piezoelectric material of the first piezoelectric layer are the same as corresponding piezoelectric tensor components $e_{31}$, $e_{32}$, $e_{33}$, $e_{14}$, $e_{24}$, $e_{15}$, $e_{25}$, and $e_{36}$ of the piezoelectric material of the second piezoelectric layer; and
piezoelectric tensor components $e_{11}$, $e_{12}$, $e_{13}$, $e_{16}$, $e_{21}$, $e_{22}$, $e_{23}$, $e_{26}$, and $e_{35}$ of the piezoelectric material of the first piezoelectric layer are opposite to corresponding piezoelectric tensor components $e_{11}$, $e_{12}$, $e_{13}$, $e_{16}$, $e_{21}$, $e_{22}$, $e_{23}$, $e_{26}$, and $e_{35}$ of the piezoelectric material of the second piezoelectric layer.

13. The resonator according to any one of claims 1 to 11, wherein

piezoelectric tensor components $e_{11}$, $e_{12}$, $e_{13}$, $e_{14}$, $e_{25}$, $e_{35}$, $e_{26}$, and $e_{36}$ of the piezoelectric material of the first piezoelectric layer are the same as corresponding piezoelectric tensor components $e_{11}$, $e_{12}$, $e_{13}$, $e_{14}$, $e_{25}$, $e_{35}$,

$e_{26}$, and $e_{36}$ of the piezoelectric material of the second piezoelectric layer; and

piezoelectric tensor components $e_{15}$, $e_{16}$, $e_{21}$, $e_{22}$, $e_{23}$, $e_{24}$, $e_{31}$, $e_{32}$, and $e_{33}$ of the piezoelectric material of the first piezoelectric layer are opposite to corresponding piezoelectric tensor components $e_{15}$, $e_{16}$, $e_{21}$, $e_{22}$, $e_{23}$, $e_{24}$, $e_{31}$, $e_{32}$, and $e_{33}$ of the piezoelectric material of the second piezoelectric layer.

14. The resonator according to any one of claims 1 to 13, wherein the first piezoelectric layer and the second piezoelectric layer are adjacent layers.

15. The resonator according to any one of claims 1 to 14, wherein polarities of the first piezoelectric layer and the second piezoelectric layer are opposite.

16. The resonator according to any one of claims 1 to 15, wherein Euler angles of a crystal of the piezoelectric material of the first piezoelectric layer are (0°, 90°, 0°), and Euler angles of a crystal of the piezoelectric material of the second piezoelectric layer are (0°, 90°, 180°); or

Euler angles of a crystal of the piezoelectric material of the first piezoelectric layer are (0°, 270°, 0°), and Euler angles of a crystal of the piezoelectric material of the second piezoelectric layer are (0°, 270°, 180°); or
Euler angles of a crystal of the piezoelectric material of the first piezoelectric layer are (90°, 90°, 210°), and Euler angles of a crystal of the piezoelectric material of the second piezoelectric layer are (90°, 90°, 30°).

17. A filter, comprising:
a plurality of electrically connected resonators, wherein at least one of the plurality of resonators is the resonator according to any one of claims 1 to 16.

18. An electronic device, comprising:

an amplifier; and
the resonator according to any one of claims 1 to 16, or the filter according to claim 17, wherein the resonator or the filter is electrically connected to the amplifier.

19. A preparation method for a resonator, comprising:

preparing a first electrode on a substrate; and
preparing a first piezoelectric layer and a second piezoelectric layer that are stacked on the first electrode, and preparing a plurality of second electrodes on the second piezoelectric layer, wherein the plurality of second electrodes are arranged side by side in a first direction; and
a piezoelectric material of the first piezoelectric layer has a first piezoelectric tensor component $e_{34}$, a piezoelectric material of the second piezoelectric layer has a second piezoelectric tensor component $e_{34}$, and the first piezoelectric tensor component $e_{34}$ is opposite to the second piezoelectric tensor component $e_{34}$.

20. The preparation method for the resonator according to claim 19, wherein preparing the first electrode on the substrate, preparing the first piezoelectric layer and the second piezoelectric layer that are stacked on the first electrode, and preparing the plurality of second electrodes on the second piezoelectric layer comprise:

preparing the first electrode on a side of a first piezoelectric wafer, bonding the substrate to the first piezoelectric wafer, and thinning the first piezoelectric wafer, to prepare the first piezoelectric layer, wherein the first electrode is located between the first piezoelectric layer and the substrate;
bonding a second piezoelectric wafer to the first piezoelectric wafer, and thinning the second piezoelectric wafer, to prepare the stacked first piezoelectric layer and second piezoelectric layer; and
preparing the plurality of second electrodes on the second piezoelectric layer.

FIG. 1

FIG. 2

FIG. 3

First direction

First side

First side — 40

E — 30

— Region Q

Second side — 20

— 10

FIG. 4

First surface — 40

— 302
} 30
— 301

First surface — 20

Second surface

— 10

FIG. 5

FIG. 6

FIG. 7

FIG. 8

FIG. 9

40

302
} 30
301

20

50

10

FIG. 10

401

402

30

20

10

FIG. 11

401

402

302

301

20

50

10

FIG. 12

First direction

L

Thickness
of a second
electrode

Thickness of a
piezoelectric layer

Thickness
of a first
electrode

401    402    401    402

302

30

301

20

10

FIG. 13

601  401  402  t2  t1  602

Pitch

Pitch

First
direction

FIG. 14

401  402

302

301

20

50

10

FIG. 15A

401        402

30

20

50

10

FIG. 15B

401        402

302

301

20

50

10

FIG. 16A

401    402

30

20

50

10

FIG. 16B

$k_t^2$ 24.2%

Weak S0 mode
in upper layer
(direction 1)

4.5    5    5.5    6    ×10⁹

freq (Hz)

FIG. 17A

FIG. 17B

FIG. 18

70

Spacing

40

h

α    α

302

30

301

20

50

10

FIG. 19

70

Spacing

40

302

30

301

20

50

10

FIG. 20

...

FIG. 21

$k_t^2$ 33.0%

freq (Hz)

FIG. 22

FIG. 23

FIG. 24

FIG. 25

| | |
|---|---|
| Prepare a first electrode on a substrate | S1 |

| | |
|---|---|
| Prepare a first piezoelectric layer and a second piezoelectric layer that are stacked on the first electrode, and prepare a plurality of second electrodes on the second piezoelectric layer, where the plurality of second electrodes are arranged side by side in a first direction, a piezoelectric material of the first piezoelectric layer has a first piezoelectric tensor component $e_{34}$, a piezoelectric material of the second piezoelectric layer has a second piezoelectric tensor component $e_{34}$, and the first piezoelectric tensor component $e_{34}$ is opposite to the second piezoelectric tensor component $e_{34}$ | S2 |

FIG. 26

50

20

First piezoelectric wafer

**FIG. 27A**

First piezoelectric wafer

20

50

10

**FIG. 27B**

First piezoelectric layer

20

50

10

**FIG. 27C**

Second piezoelectric wafer

First piezoelectric layer

20

50

10

FIG. 27D

Second piezoelectric layer

First piezoelectric layer

20

50

10

FIG. 27E

40

Second piezoelectric layer

First piezoelectric layer

20

50

10

FIG. 27F

400    410    420

IN o—[400]—[410]—[420]—o OUT

430    440

GND o———————o GND

FIG. 28

Out-of-band rejection    Passband    Out-of-band rejection

420

Series resonators

410

400

440 430

Parallel resonators

FIG. 29

## INTERNATIONAL SEARCH REPORT

| International application No. |
|---|
| **PCT/CN2024/115982** |

**A.  CLASSIFICATION OF SUBJECT MATTER**

H03H 9/17(2006.01)i

According to International Patent Classification (IPC) or to both national classification and IPC

**B.  FIELDS SEARCHED**

Minimum documentation searched (classification system followed by classification symbols)

IPC:  H03H

Documentation searched other than minimum documentation to the extent that such documents are included in the fields searched

Electronic data base consulted during the international search (name of data base and, where practicable, search terms used)

VEN, CNABS, CNTXT, EPTXT, USTXT, WOTXT, CNKI, IEEE: 第二压电, 体声波, 谐振器, 滤波器, 欧拉角, 切割角, 张量, second piezoelectric layer, BAR, electrode, resonator, wave filter, euler angle, cutting angle, tensor

**C.  DOCUMENTS CONSIDERED TO BE RELEVANT**

| Category* | Citation of document, with indication, where appropriate, of the relevant passages | Relevant to claim No. |
|---|---|---|
| X | CN 111431501 A (SHANGHAI INSTITUTE OF MICROSYSTEM AND INFORMATION TECHNOLOGY, CHINESE ACADEMY OF SCIENCES) 17 July 2020 (2020-07-17) description, paragraphs 47-101, and figures 1-5 | 1-20 |
| A | CN 114124021 A (SHANGHAI INSTITUTE OF MICROSYSTEM AND INFORMATION TECHNOLOGY, CHINESE ACADEMY OF SCIENCES) 01 March 2022 (2022-03-01) entire document | 1-20 |
| A | CN 114710133 A (NANJING UNIVERSITY) 05 July 2022 (2022-07-05) entire document | 1-20 |
| A | CN 114944829 A (UNIVERSITY OF ELECTRONIC SCIENCE AND TECHNOLOGY OF CHINA) 26 August 2022 (2022-08-26) entire document | 1-20 |
| A | US 2018175826 A1 (QORVO US, INC.) 21 June 2018 (2018-06-21) entire document | 1-20 |

☐ Further documents are listed in the continuation of Box C.       ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **24 October 2024** | **11 November 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/115982**

| Patent document cited in search report | | | Publication date (day/month/year) | Patent family member(s) | Publication date (day/month/year) |
|---|---|---|---|---|---|
| CN | 111431501 | A | 17 July 2020 | None | |
| CN | 114124021 | A | 01 March 2022 | None | |
| CN | 114710133 | A | 05 July 2022 | None | |
| CN | 114944829 | A | 26 August 2022 | None | |
| US | 2018175826 | A1 | 21 June 2018 | None | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311635958